# EUROPEAN PATENT APPLICATION

(11) **EP 4 700 819 A1**
(43) Date of publication of application: **25.02.2026**
(21) Application number: 25190716.8
(22) Date of filing: 21.07.2025
(51) Int. Cl.: H01J 37/26, H01J 37/28

(54) **MULTIMODAL SIGNAL ACQUISITION SYNCHRONIZED BY UNIVERSAL CLOCK**

(30) Priority: 19.08.2024 US 202418808549
(71) Applicant: FEI COMPANY, Hillsboro, OR 97124 (US)
(72) Inventor: Freitag, Bert Henning, Hermann (DE); Kieft, Erik René, Eindhoven (NL); Potocek, Pavel, Eindhoven (NL); Vespucci, Stefano, Eindhoven (NL)
(74) Representative: Robinson, Louise Frances

(57) **Abstract**

Embodiments described herein relate to a process for multimodal signal acquisition, such as from a charged particle device or other scientific instrument, based on universal clock synchronization of the various multimodal signals. A system can comprise a memory that stores computer executable components; and a processor that executes the computer executable components stored in the memory, wherein the computer executable components comprise an identifying component that identifies a set of inputs and outputs of a scientific instrument, and a parameterizing component that tracks the inputs and outputs of the set based on a universal clock common to the inputs and outputs of the set.

## Description

### BACKGROUND

Scientific experiments can comprise acquiring input and output signals based on varying timelines and other tracking methods, such as based on a position in two-dimensional or three-dimensional space. Analysis of these various signals, such as including comparison of signals using different timelines and/or tracking methods can be a difficult process due to gaps in data, tracking method jumps due to environmental disturbances, and/or lack of relation between tracking methods. As a result, an aggregated signal acquisition set can resemble a complex tangle of data that can be difficult and/or impossible to determine relationships for.

### BRIEF DESCRIPTION OF THE DRAWINGS

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 illustrates a block diagram of an example scientific instrument for performing one or more operations, in accordance with one or more embodiments described herein.
FIG. 2 illustrates a flow diagram of an example method of performing operations using the scientific instrument of FIG. 1, in accordance with one or more embodiments described herein.
FIG. 3 illustrates a graphical user interface (GUI) that can be used in the performance of one or more of the methods described herein, in accordance with one or more embodiments described herein.
FIG. 4 illustrates a block diagram of an example computing device that can perform one or more of the methods disclosed herein, in accordance with one or more embodiments described herein.
FIG. 5 illustrates a block diagram of an example, non-limiting system that can facilitate a process for tracking input and out signal acquisitions, in accordance with one or more embodiments described herein.
FIG. 6 illustrates a block diagram of another example, non-limiting system that can facilitate a process for tracking input and out signal acquisitions, in accordance with one or more embodiments described herein.
FIG. 7 illustrates a flow diagram of a signal acquisition workflow that can be obtained by the non-limiting system of FIG. 6, in accordance with one or more embodiments described herein.
FIG. 8 illustrates a flow diagram of a signal acquisition tracking workflow that can be performed by the non-limiting system of FIG. 6, in accordance with one or more embodiments described herein.
FIG. 9 illustrates another flow diagram of a signal acquisition tracking workflow that can be performed by the non-limiting system of FIG. 6, in accordance with one or more embodiments described herein.
FIG. 10 illustrates a flow diagram of one or more processes that can be performed by a signal tracking system of FIG. 5, in accordance with one or more embodiments described herein.
FIG. 11 illustrates another flow diagram of one or more processes that can be performed by the signal tracking system of FIG. 6, in accordance with one or more embodiments described herein.
FIG. 12 illustrates a continuation of the flow diagram of FIG. 11 of one or more processes that can be performed by the signal tracking system of FIG. 6, in accordance with one or more embodiments described herein.
FIG. 13 illustrates a block diagram of example scientific instrument system in which one or more of the methods described herein can be performed, in accordance with one or more embodiments described herein.
FIG. 14 illustrates a block diagram of an example operating environment into which embodiments of the subject matter described herein can be incorporated.
FIG. 15 illustrates an example schematic block diagram of a computing environment with which the subject matter described herein can interact and/or be implemented at least in part.

### SUMMARY

The following presents a summary to provide a basic understanding of one or more embodiments described herein. This summary is not intended to identify key or critical elements, and/or to delineate scope of particular embodiments or scope of claims. Its sole purpose is to present concepts in a simplified form as a prelude to the more detailed description that is presented later. In one or more embodiments, systems, computer-implemented methods, apparatuses and/or computer program products described herein can provide a plug-and-play process for generating identifiers, and/or updating a library datastore with such identifiers, based at least partially on an annotation ranking schema.

In accordance with an embodiment, a system can comprise a memory that stores computer executable components; and a processor that executes the computer executable components stored in the memory, wherein the computer executable components comprise an identifying component that identifies a set of inputs and outputs of a scientific instrument, and a parameterizing component that tracks the inputs and outputs of the set based on a universal clock common to the inputs and outputs of the set

In accordance with another embodiment, a computer-implemented method can comprise identifying, by a system operatively coupled to a processor, a set of inputs and outputs of a scientific instrument, and tracking, by the system, the inputs and outputs of the set based on a universal clock common to the inputs and outputs of the set.

In accordance with still another embodiment, a computer program product facilitates a process for tracking scientific device inputs and outputs, the computer program product comprising a computer readable storage medium having program instructions embodied therewith, and the program instructions executable by a processor to cause the processor to identify, by the processor, a set of inputs and outputs of a scientific instrument, and track, by the processor, the inputs and outputs of the set based on a universal clock common to the inputs and outputs of the set.

The one or more embodiments described herein can be implemented within, in connection with and/or coupled to a scientific imaging device or other scientific instrument, such as a charged particle device.

The one or more embodiments described herein can be employed with varying (e.g., multimodal) signal types comprising, but not limited to, stimulus, detection, scan, optics, magnetic, electric phase transition and/or dynamic excitation. Each of these signal types can employ the universal clock, thus allowing for inputs and/or outputs of these signal types to be tracked and analyzed relative to one another absent loss of data, time conversion, etc. Further, environmental disturbances, such as causing a change in an XY position due to a physical instability, bump, vibration, etc., do not alter the universal clock because such clock is not based on XY position alone.

As a result, parameters can be easily ordered relative to one another, thus allowing for identification of one or more interference frequencies of the environment disturbing another signal, such as an image output signal, and separating out such one or more interference frequencies.

In one or more cases, based on the one or more embodiments described herein, one or more experiment types can be performed that cannot be performed using existing frameworks. For example, coincidence measurement and critical dose measurements can benefit from signal comparison provided by use of a common universal clock and lack of signal tracking loss (e.g., from use of XY position to track serially obtained signals, as in existing frameworks).

In one or more cases, reduced storage space and bandwidth can be employed to store and record signals due to ability to omit recording of XY position outputs corresponding to beam blanking, based on use of the one or more embodiments described herein.

The one or more embodiments described herein can be applied on a plug-and-play basis to various architectures of existing scientific instruments, signal acquisition instruments, and/or the like. For example, areas/fields of catalysis, metallics, ceramics, magnetic phase transition, electric phase transition, light stimulus, and/or liquid cell research are among those that can benefit from a process for tracking scientific device inputs and outputs relative to a common universal clock.

### DETAILED DESCRIPTION

The following detailed description is merely illustrative and is not intended to limit embodiments and/or application or utilization of embodiments. Furthermore, there is no intention to be bound by any expressed or implied information presented in the preceding Summary section, or in the Detailed Description section. One or more embodiments are now described with reference to the drawings, wherein like reference numerals are utilized to refer to like elements throughout. In the following description, for purposes of explanation, numerous specific details are set forth in order to provide a more thorough understanding of the one or more embodiments. It is evident, however, in various cases, that the one or more embodiments can be practiced without these specific details.

Various operations can be described as multiple discrete actions or operations in turn, in a manner that is most helpful in understanding the subject matter disclosed herein. However, the order of description should not be construed as to imply that these operations are necessarily order dependent. In particular, these operations can be performed in an order different from the order of presentation. Operations described can be performed in a different order from the described embodiment. Various additional operations can be performed, and/or described operations can be omitted in additional embodiments.

Turning now to the general subject of signal acquisition, such process can be performed in a plurality of experimental, information gathering, monitoring, industrial, manufacturing and/or other scientific processes. Often a plurality of different signal types are desired to be acquired at least partially in parallel with one another. Such signal types can comprise, but are not limited to stimulus, detection, scan, optics, magnetic, electric phase transition and/or dynamic excitation signals. These signals can be analyzed offline (e.g., separate from running of a respective process, experiment, etc.) and/or online (e.g., during running of the respective process, experiment, etc.).

Part of such analysis can be desired comparison of different signals having occurred at a same time, relative to a same position, etc. This analysis can be fraught with difficulty due to signal loss, signal jump, and/or incomparable reference points (e.g., timelines and other tracking methods). For example, different tracking methods, and even different timelines can have unknown time jumps, tracking jumps, loss of data, etc. In one or more cases, an environmental disturbance, such as a vibration, bump, etc. can affect signal acquisition causing a change in the signals obtained and/or reference tracking employed. Due to these occurrences, comparison between different signal types can be difficult, taking undesirable amounts of bandwidth, time, power and/or labor, if not being altogether impossible.

One such example can comprise image acquisition using a scanning transmission electron microscope (STEM) or other scientific imaging device. Operation of such STEM device can comprise acquiring signals related to stimulus, detection, scan, optics, etc., based on different timelines, XY positions and/or other tracking methods. These signal types can be acquired at least partially at a same time as one another. However, the various signal sets can be non-synchronized and non-linked. Accordingly, event documentation can be difficult due to the deficiencies noted above. For example, a vibration can cause movement of an X position, Y position or XY position (e.g., either or both of X and Y positions). Accordingly, one signal type can be based on XY position where another can be based on serial timepoint gathering. As a result, ordering of data based on the signals obtained can be difficult due to invariance of time but instable XY position. Further, based thereon, correlation errors can be introduced into artifact compensation and/or dynamic behavior analysis based on the signals obtained/data obtained therefrom.

These correlation errors can be difficult to discern and/or filter out. In one or more cases, such correlation errors can go unrecognized resulting in inaccurate data. In one or more cases, such correlation errors can cause loss of data, misaligned signal/data correlation, and/or inability to align signals/data with one another. In one or more cases, such correlation errors can lead to undesirable amounts of bandwidth, time, power and/or labor related to event documentation and/or dynamic experiment setup. Indeed, such correlation errors can lead to difficult reproducing such dynamic experiments.

Another such example can involve dynamic excitation via lasers, where holders, or other devices positioned in an electron beam line, can employ a clock to monitor variations of a stimulus parameter in time separate from an excitation clock employed to monitor excitation. Phase locked experiments can be non-possible due to non-linking of the respective timelines. As a result, events on an illumination side of such experiment are non-linked to events on a detection side of the experiment, in time.

Put another way, a STEM scanning experiment can comprise a serial acquisition of visited scan points as well as a serial acquisition in time space by visiting the scan points in a sequence of points in time. This can mean that at least an XY position is different from other dynamically changed optical aspects (e.g., deflectors, blankers, stimulus, etc.), and thus the detected signals can be non-linked. As a result, stamping data obtained from the signals with a time of an event can be impossible or undesirably difficult. To allow for such stamping, the various signals are to be synchronized to an event stream. This can lead to an ordering parameter which can be altered by environmental disturbance to the experiment and/or system operating the experiment.

To account for one or more deficiencies of such existing frameworks, one or more embodiments are described herein that can provide increase of accuracy and/or efficiency of data correlation based on multimodal signal acquisition of varying types. The varying signals can be based on varying timelines, clocks and/or other tracking methods but synchronized, by the one or more embodiments described herein, to a single or common universal clock.

That is, a STEM scanning experiment addressed by the one or more embodiments described herein can comprise a serial acquisition of visited scan points as well as a serial acquisition in time space by visiting the scan points in a sequence of points in time. Based on use of a common universal clock, and non-use of XY position as a tracking method, an XY position can be as other dynamically changed optical aspects (e.g., deflectors, blankers, stimulus, etc.) and the detected signals can be stamped with a time of an event. To allow for such stamping, the various signals can be synchronized to an event stream based on the common universal clock. This can include stamping the XY position (e.g., parameterizing the XY position) with a time stamp akin to the signals of detectors, active blankers and/or ultrafast cavity components. As a result, an ordering parameter can be employed that is not altered by environmental disturbances like conventional XY position because time is invariant, while XY position can be different due to instabilities thereof.

In one or more cases, by time stamping all events a five-dimensional (5D) space can be generated in static experiments for X position of the beam or for Y position of the beam. The 5D space in static experiments can further comprise the energy loss spectrum of energy dispersive x-ray spectrum (e.g., approximately 0-40keV) or an electron energy loss spectrum (e.g., approximately 0-40keV), represented as dE. The 5D space in static experiments can further comprise the electrons detected below the specimen under different scattering angles kx and ky, such as in the range of 0-300 milliradian half angle. Additionally, and/or alternatively, detecting the signal above the sample of backscattered electrons and/or secondary electrons and cathodoluminescence can increase the dimensionality of the time stamped space. Additionally, and/or alternatively, a seven-dimensional space can further be generated and can include electron use or no electron use and stimulus dynamics in non-static experiments.

One or more benefits can comprise better instability compensation by software and/or hardware, whether or not using artificial intelligence analysis, of multimodal signals. As used herein, the term "multimodal" refers to having varying types of signals or other tracked data, also referred to herein as signals. Examples can comprise, but are not limited to stimulus, optics, scan, detection and/or excitation signals and/or XY position.

For example, relative to better instability compensation by software, when having a time axis as a reference for the signals of a STEM image or for maps of spectroscopic signals it can be possible to look for interference frequencies of the environment disturbing the images and can allow for separation of such interference frequencies from the desired signals. Environmental disturbances and/or interference frequences can comprise, but are not limited to, drift in time of energy axis (EELS), drift, vibrations, and/or fixed frequencies in real space (e.g., X& position artifacts). Frequencies in energy space can be found back in real space and correlations can allow for identifying frequencies better for compensation by software in view of the one or more embodiments described herein.

For another example, relative to better instability compensation by hardware, when scanning with a fastest speed of a scan unit, a dwell time per pixel can be defined by how often the pixel is visited. A time series of the signals in the pixel can provide information on damage and/or scan artifacts when analyzed. It is noted that when using a variable dwell time, only one point in time is provided, making this analysis impossible. When using existing frameworks, the compensation can be performed on an entire frame, which can allow to compensate for drift, but not for frequencies (flagging) or degradation of a specimen (damage). Differently, using the one or more embodiments described herein, and using a fastest dwell time to distribute energy more evenly, this can be addressed by synchronized tracking. Additionally, and/or alternatively, gradience of temperature, gradience of electrons (charging) causing damage, and/or artifacts of a scan can be addressed by synchronized tracking.

Additionally, and/or alternatively, one or more other benefits can comprise ability to relate various different types of signals (e.g., to relate multimodal signals), lack of effect of environmental disturbances on the acquired signals, ability to easily separate out undesirable frequencies, ability to employ new types of dynamic experiments, ability to employ a system described herein with various signal acquisition frameworks (e.g., various different hardware, software and/or firmware), application of the one or more embodiments described herein to a plurality of different industries, and/or reduction in time, energy, memory and/or bandwidth employed for signal acquisition due to non-recording of signals/data points corresponding to beam blanking.

Discussion next turns to a general discussion of one or more scientific instrument systems disclosed herein, as well as to related methods, computing devices, and/or computer-readable media. For example, in one or more embodiments, a system can comprise a memory that stores computer executable components; and a processor that executes the computer executable components stored in the memory, wherein the computer executable components comprise an identifying component that identifies a set of inputs and outputs of a scientific instrument, and a parameterizing component that tracks the inputs and outputs of the set based on a universal clock common to the inputs and outputs of the set.

The one or more embodiments disclosed herein can achieve improved performance relative to existing approaches, as noted above. For example, based on application of a common universal clock to track XY position and other signals acquired (e.g., multimodal signals acquired), this can allow for inputs and/or outputs of these signal types to be tracked and analyzed relative to one another absent loss of data, time conversion, etc. Further, environmental disturbances, such as causing a change in an XY position due to a physical instability, bump, vibration, etc., do not alter the universal clock because such clock is not based on XY position alone.

The embodiments disclosed herein thus can provide improvements to scientific instrument technology (e.g., improvements in the computer technology supporting such scientific instruments, among other improvements), which can be employed for sample analysis in various fields including optics, signal processing, spectroscopy (e.g., electron energy loss spectroscopy, mass spectroscopy, or electron spectroscopy), microscopy (e.g., electron microscopy, transmission electron microscopy, or scanning transmission electron microscopy), and/or nuclear magnetic resonance (NMR), without being limited thereto. Other applicable fields can comprise those related to catalysis, metallics, ceramics, magnetic phase transition, electric phase transition, light stimulus, and/or liquid cell research, without being limited thereto.

Various ones of the embodiments disclosed herein can improve upon existing approaches to achieve the technical advantages of high information and/or accurate information analysis based on multimodal signal acquisition from which such information can be obtained. That is, the one or more embodiments described herein can provide parameterizing of various signal inputs and/or outputs of a same experiment, operation and/or process, while allowing for identification of one or more interference frequencies of the environment disturbing another signal, such as an image output signal, and separating out such one or more interference frequencies.

In one or more cases, based on the one or more embodiments described herein, one or more experiment types can be performed that cannot be performed using existing frameworks. For example, coincidence measurement and critical dose measurements can benefit from signal comparison provided by use of a common universal clock and lack of signal tracking loss (e.g., from use of XY position to track serially obtained signals, as in existing frameworks).

In one or more cases, reduced storage space and bandwidth can be employed to store and record signals due to ability to omit recording of XY position outputs corresponding to beam blanking, based on use of the one or more embodiments described herein.

The one or more embodiments described herein can be applied on a plug-and-play basis to various architectures of existing scientific instruments, signal acquisition instruments, and/or the like.

These can be useful applications and/or processes for varying industries employing material analysis, product manufacturing, quality control and/or the like. The embodiments disclosed herein thus can provide improvements to scientific instrument technology (e.g., improvements in the computer technology supporting such scientific instruments, among other improvements).

Such technical advantages are not achievable by routine and/or existing approaches, as described above, and all user entities of systems including such embodiments can benefit from these advantages (e.g., by assisting the user entity in the performance of a technical task, such as cross-modal information analysis based on multimodal signal acquisition.

The technical features of the embodiments disclosed herein (e.g., application of a common universal clock, time stamping according to the common universal clock, identification of interfering frequencies, etc.) are thus decidedly unconventional in signal acquisition for the general field of material analysis, in addition to the fields of optics, signal processing, spectroscopy, and/or NMR, without being limited thereto, as are combinations of the features of the embodiments disclosed herein.

As discussed further herein, various aspects of the embodiments disclosed herein can improve the functionality of a computer itself. That is, the computational and/or user interface features disclosed herein do not involve only the collection and/or comparison of information but instead can apply new analytical and technical techniques to change the operation of the computer-analysis of material compounds. For example, as a common universal clock is employed, allowing for generation and application of time stamps that can be related to one another absent variance, such as due to environmental influences, comparisons for determining relationships between signals acquired, determination of events based on multimodal signals, and/or the like, such as can be performed by a classical computer and/or by one or more artificial intelligences employing the results of the one or more embodiments described herein, can become more efficient and accurate over time. That is, as signals are acquired and synchronized according to a common universal clock, without use of variable XY position as a synchronizing element, but rather synchronizing XY position along with other inputs and outputs, a larger body of accurate comparative data is generated for use in searches, queries, event determinations, signal comparisons and/other analyses performed relative to the various multimodal signals synchronized one or more embodiments described herein. As such, one or more non-limiting systems described herein, comprising a signal tracking system, as described herein, can be self-improving.

The present disclosure thus introduces functionality that neither an existing computing device, nor a human, could perform. Rather, such existing computing devices are ineffective at analyzing multimodal acquired signal data without a need to account for XY position variance and/or environmental disturbance data, and/or at synchronizing multimodal signals including serial tracking of XY position, as the one or more embodiments described herein can provide this process. In view of the time, energy and/or loss of data involved, it is not practical to operate within the confines of existing approaches.

Accordingly, the embodiments of the present disclosure can serve any of a number of technical purposes, such as controlling a specific technical system or process; determining from measurements how to control a machine; digital audio, image, or video enhancement or analysis; separation of material sources in a mixed signal; generating data for reliable and/or efficient transmission or storage; providing estimates and confidence intervals for material samples; or providing a faster processing of sensor data. In particular, the present disclosure provides technical solutions to technical problems, including, but not limited to, hologram modification; image/signal blurring; application of combined blurring techniques; and/or subsequent image reconstruction, resulting in a faster, more thorough and/or more efficient processing of generated images and thus of material samples or other target compositions being imaged.

The embodiments disclosed herein thus provide improvements to material analysis technology (e.g., improvements in the computer technology supporting material analysis, among other improvements).

As used herein, the phrase "based on" should be understood to mean "based at least in part on," unless otherwise specified.

As used herein, the term "component" can refer to an atomic element, molecular element, phase of an atomic or molecular element, or combination thereof.

As used herein, the term "data" can comprise metadata.

As used herein, the terms "entity," "requesting entity," and "user entity" can refer to a machine, device, component, hardware, software, smart device, party, organization, individual and/or human.

As used herein, the term "sample" can refer to a single material, multiple materials, composition, compound, solution, product, etc.

As used herein, the term "signal" can refer to an input and/or output communication, transmission, reading, etc. provided in any suitable format comprising, but not limited to, digital data, electrical, fiberoptic, magnetic, optical, light, audible, sound, vibration, and/or tactile.

One or more embodiments are now described with reference to the drawings, where like referenced numerals are used to refer to like drawing elements throughout. In the following description, for purposes of explanation, numerous specific details are set forth in order to provide a more thorough understanding of the one or more embodiments. It is evident in various cases, however, that the one or more embodiments can be practiced without these specific details.

Further, it should be appreciated that the embodiments depicted in one or more figures described herein are for illustration only, and as such, the architecture of embodiments is not limited to the systems, devices and/or components depicted therein, nor to any particular order, connection and/or coupling of systems, devices and/or components depicted therein.

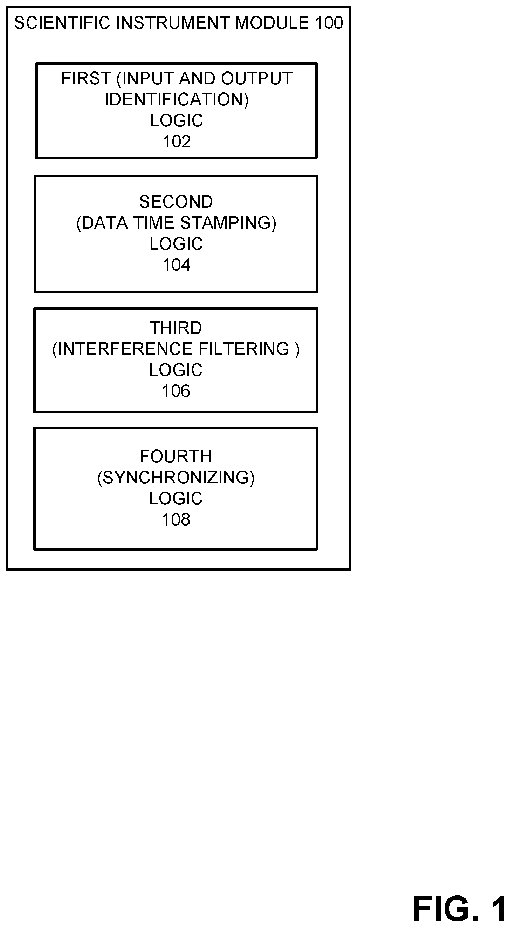

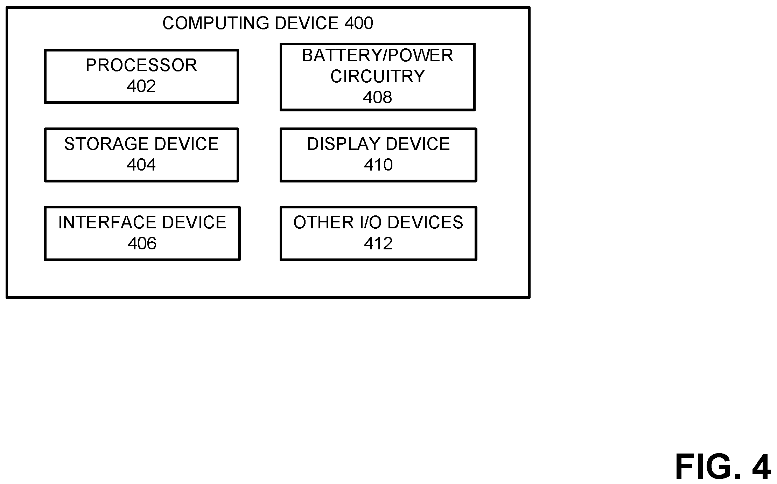

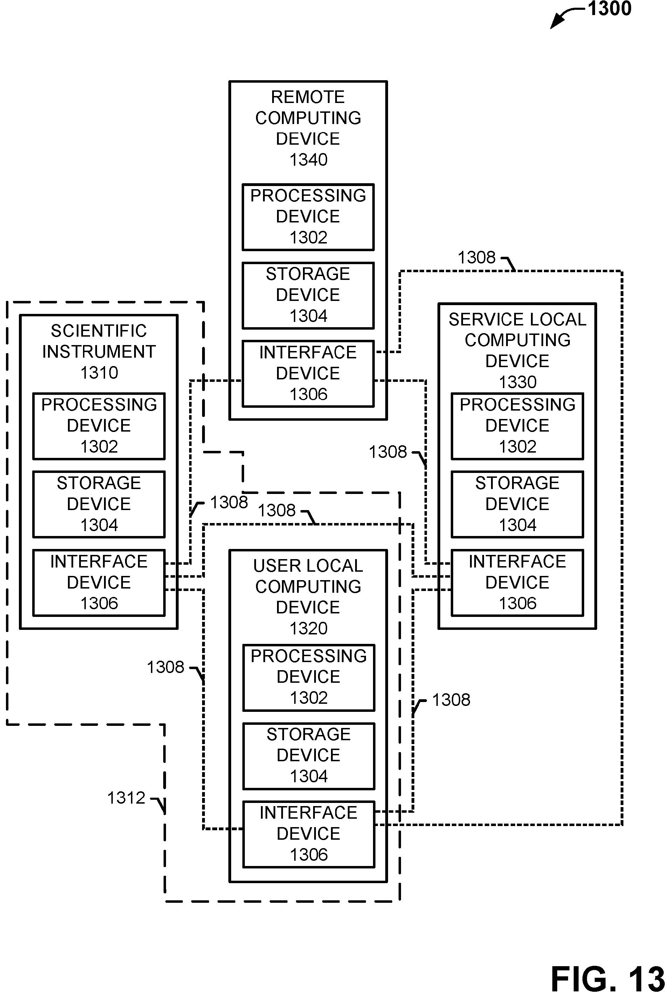

Turning now in particular to the one or more figures, and first to FIG. 1, illustrated is a block diagram of a scientific instrument module 100 for performing material analysis operations using a signal tracking process, in accordance with various embodiments described herein. The scientific instrument module 100 can be implemented by circuitry (e.g., including electrical and/or optical components), such as a programmed computing device. The logic of the scientific instrument module 100 can be included in a single computing device or can be distributed across multiple computing devices that are in communication with each other as appropriate. Examples of computing devices that can, singly or in combination, implement the scientific instrument module 100 are discussed herein with reference to the computing device 400 of FIG. 4, and examples of systems of interconnected computing devices, in which the scientific instrument module 100 can be implemented across one or more of the computing devices, is discussed herein with reference to the scientific instrument system 1300 of FIG. 13.

The scientific instrument module 100 can include first logic 102, second logic 104, third logic 106, and fourth logic 108. As used herein, the term "logic" can include an apparatus that is to perform a set of operations associated with the logic. For example, any of the logic elements included in the module 100 can be implemented by one or more computing devices programmed with instructions to cause one or more processing devices of the computing devices to perform the associated set of operations. In a particular embodiment, a logic element can include one or more non-transitory computer-readable media having instructions thereon that, when executed by one or more processing devices of one or more computing devices, cause the one or more computing devices to perform the associated set of operations. As used herein, the term "module" can refer to a collection of one or more logic elements that, together, perform a function associated with the module. Different ones of the logic elements in a module can take the same form or can take different forms. For example, some logic in a module can be implemented by a programmed general-purpose processing device, while other logic in a module can be implemented by an application-specific integrated circuit (ASIC). In another example, different ones of the logic elements in a module can be associated with different sets of instructions executed by one or more processing devices. A module can omit one or more of the logic elements depicted in the associated drawing; for example, a module can include a subset of the logic elements depicted in the associated drawing when that module is to perform a subset of the operations discussed herein with reference to that module.

The first logic 102 can receive, find, locate, download, request, measure and/or otherwise determine a set of signals and thus a set of inputs and outputs (e.g., data and/or metadata) corresponding to the set of signals. That is, the first logic 102 can obtain data for being processed and for subsequent use in generating a time stamp and/or executing a signal comparison.

The second logic 104 can perform a data time stamping process by generally time stamping the inputs and outputs with time stamps based on data output from a universal clock. That is, the second logic 104 can employ the output of the first logic 102 as a trigger for the second logic 104.

The third logic 106 can track the inputs and outputs according to the universal clock and based on the time stamps output from the second logic 104, by particularly filtering out an interference frequency corresponding to an interference output of the inputs and outputs. That is, the third logic 106 can employ an output of the second logic 104 to perform the third logic 106.

The fourth logic 108 can analyze data output from the universal clock to particularly synchronize another clock with the universal clock.

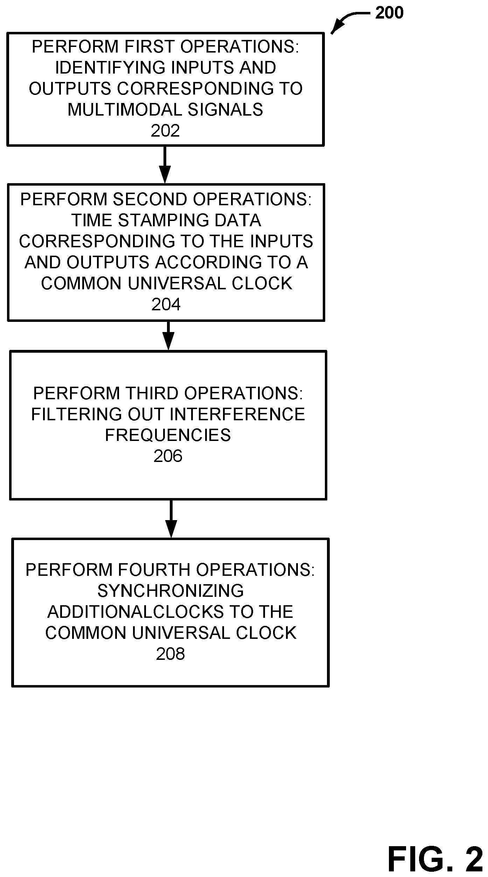

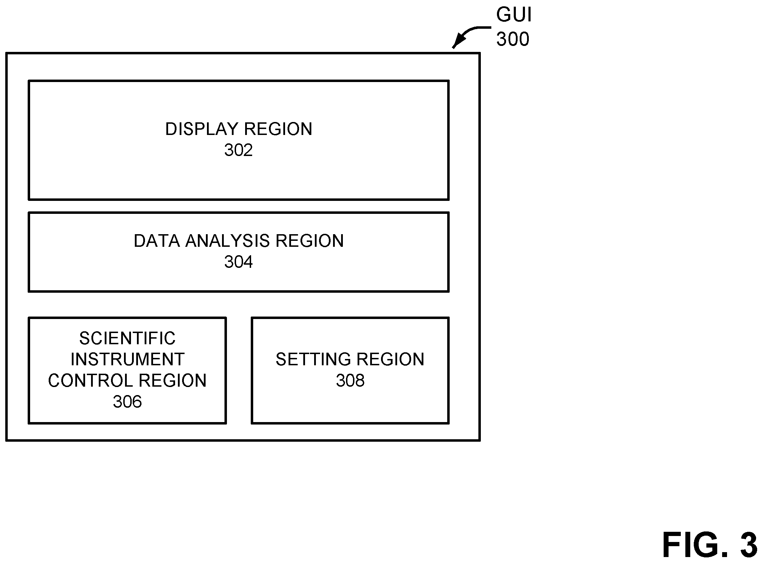

FIG. 2 illustrates a flow diagram of a method 200 of performing operations, by the scientific instrument module 100, in accordance with various embodiments. Although the operations of the method 200 can be illustrated with reference to particular embodiments disclosed herein (e.g., the scientific instrument module 100 discussed herein with reference to FIG. 1, the GUI 300 discussed herein with reference to FIG. 3, the computing device 400 discussed herein with reference to FIG. 4, and/or the scientific instrument system 1300 discussed herein with reference to FIG. 13), the method 200 can be used in any suitable setting to perform any suitable operations. Operations are illustrated once each and in a particular order in FIG. 2, but the operations can be reordered and/or repeated as desired and appropriate (e.g., different operations performed can be performed in parallel, as suitable).

At 202, first operations can be performed. For example, the first logic 102 of the module 100 can perform the first operations 202. The first operations 202 can include receiving, finding, locating, downloading, requesting, measuring and/or otherwise determining a set of signals and thus a set of inputs and outputs (e.g., data and/or metadata) corresponding to the set of signals.

At 204, second operations can be performed. For example, the second logic 104 of the module 100 can perform the second operations 204. The second operations 204 can comprise using data output from a universal clock, as compared to metadata associated with inputs and outputs to generate and apply time stamps to the inputs and outputs, according to the universal clock.

At 206, third operations can be performed. For example, the third logic 106 of the module 100 can perform the third operations 206. The third operations 206 can comprise analyzing the inputs and outputs according to the time stamps to determine an interference frequency output correlating to interference at least partially overlapping an imaging output and filtering out the undesirable interference frequency output.

At 208, fourth operations can be performed. For example, the fourth logic 108 of the module 100 can perform the fourth operations 208. The fourth operations 208 can comprise analyzing the data output from the universal clock to synchronize another clock, such as an excitation clock, with the universal clock.

The scientific instrument methods disclosed herein can include interactions with a user entity (e.g., via the user local computing device 1320 discussed herein with reference to FIG. 13). These interactions can include providing information to the user entity (e.g., information regarding the operation of a scientific instrument such as the scientific instrument 1310 of FIG. 13, information regarding a sample being analyzed or other test or measurement performed by a scientific instrument, information retrieved from a local or remote database, or other information) or providing an option for a user entity to input commands (e.g., to control the operation of a scientific instrument such as the scientific instrument 1310 of FIG. 13, or to control the analysis of data generated by a scientific instrument), queries (e.g., to a local or remote database), or other information. In some embodiments, these interactions can be performed through a graphical user interface (GUI) that includes a visual display on a display device (e.g., the display device 410 discussed herein with reference to FIG. 4) that provides outputs to the user entity and/or prompts the user entity to provide inputs (e.g., via one or more input devices, such as a keyboard, mouse, trackpad, or touchscreen, included in the other I/O devices 412 discussed herein with reference to FIG. 4). The scientific instrument system 1300 disclosed herein can include any suitable GUIs for interaction with a user entity.

Turning next to FIG. 3, depicted is an example GUI 300 that can be used in the performance of one or more of the methods described herein, in accordance with various embodiments described herein. As noted above, the GUI 300 can be provided on a display device (e.g., the display device 410 discussed herein with reference to FIG. 4) of a computing device (e.g., the computing device 400 discussed herein with reference to FIG. 4) of a scientific instrument system (e.g., the scientific instrument system 1300 discussed herein with reference to FIG. 13), and a user entity can interact with the GUI 300 using any suitable input device (e.g., any of the input devices included in the other I/O devices 412 discussed herein with reference to FIG. 4) and input technique (e.g., movement of a cursor, motion capture, facial recognition, gesture detection, voice recognition, actuation of buttons, etc.).

The GUI 300 can include a data display region 302, a data analysis region 304, a scientific instrument control region 306, and a settings region 308. The particular number and arrangement of regions depicted in FIG. 3 is merely illustrative, and any number and arrangement of regions, including any desired features thereof, can be included in a GUI 300.

The data display region 302 can display data generated by a scientific instrument (e.g., the scientific instrument 1310 discussed herein with reference to FIG. 13). For example, the data display region 302 can display one or more output results which can comprise one or more timings, signal frequencies, inputs, outputs, time stamps, etc., without being limited thereto.

The data analysis region 304 can display the results of data analysis (e.g., the results of analyzing the data illustrated in the data display region 302 and/or other data). For example, the data analysis region 304 can display one or more analysis comparing a pair of signals based on their respective time stamps. In one or more embodiments, the data display region 302 and the data analysis region 304 can be combined in the GUI 300 (e.g., to include data output from a scientific instrument, and some analysis of the data, in a common graph or region).

The scientific instrument control region 306 can include options that allow the user entity to control a scientific instrument (e.g., the scientific instrument 1310 discussed herein with reference to FIG. 13). For example, the scientific instrument control region 306 can include one or more controls for customizing a quantity of data being analyzed (e.g., number of signals, range of frequencies, range of time of signals, etc.).

The settings region 308 can include options that allow the user entity to control the features and functions of the GUI 300 (and/or other GUIs) and/or perform common computing operations with respect to the data display region 302 and data analysis region 304 (e.g., saving data on a storage device, such as the storage device 404 discussed herein with reference to FIG. 4, sending data to another user entity, labeling data with a time stamp, etc.). For example, the settings region 308 can include one or more options to alter color, fill or format of illustrations, such as an illustration of one or more signals acquired and tracked.

As noted above, the scientific instrument module 100 can be implemented by one or more computing devices. Accordingly, discussion next turns to FIG. 4, which illustrates a block diagram of a computing device 400 that can perform some or all of the scientific instrument methods disclosed herein, in accordance with various embodiments. In one or more embodiments, the scientific instrument module 100 can be implemented by a single computing device 400 or by multiple computing devices 400. Further, as discussed below, a computing device 400 (or multiple computing devices 400) that implements the scientific instrument module 100 can be part of one or more of the scientific instrument 1310, the user local computing device 1320, the service local computing device 1330, or the remote computing device 1340 of FIG. 13.

The computing device 400 of FIG. 4 is illustrated as having a number of components, but any one or more of these components can be omitted or duplicated, as suitable for the application and setting. As illustrated, these components can include one or more of a processor 402, storage device 404, interface device 406, battery/power circuitry 408, display device 410 and other input/output (I/O) devices 412, as will be described below.

In one or more embodiments, one or more of the components included in the computing device 400 can be attached to one or more motherboards and enclosed in a housing (e.g., including plastic, metal, and/or other materials). In one or more embodiments, some these components can be fabricated onto a single system-on-a-chip (SoC) (e.g., an SoC can include one or more processors 402 and one or more storage devices 404). Additionally, in one or more embodiments, the computing device 400 can omit one or more of the components illustrated in FIG. 4. In one or more embodiments, the computing device 400 can include interface circuitry (not shown) for coupling to the one or more components using any suitable interface (e.g., a Universal Serial Bus (USB) interface, a High-Definition Multimedia Interface (HDMI) interface, a Controller Area Network (CAN) interface, a Serial Peripheral Interface (SPI) interface, an Ethernet interface, a wireless interface, or any other appropriate interface). For example, the computing device 400 can omit a display device 410, but can include display device interface circuitry (e.g., a connector and driver circuitry) to which a display device 410 can be coupled.

The computing device 400 can include the processor 402 (e.g., one or more processing devices). As used herein, the term "processing device" can refer to any device or portion of a device that processes electronic data from registers and/or memory to transform that electronic data into other electronic data that can be stored in registers and/or memory. The processor 402 can include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

The computing device 400 can include a storage device 404 (e.g., one or more storage devices). The storage device 404 can include one or more memory devices such as random access memory (RAM) (e.g., static RAM (SRAM) devices, magnetic RAM (MRAM) devices, dynamic RAM (DRAM) devices, resistive RAM (RRAM) devices, or conductive-bridging RAM (CBRAM) devices), hard drive-based memory devices, solid-state memory devices, networked drives, cloud drives, or any combination of memory devices. In one or more embodiments, the storage device 404 can include memory that shares a die with a processor 402. In such an embodiment, the memory can be used as cache memory and can include embedded dynamic random-access memory (eDRAM) or spin transfer torque magnetic random-access memory (STT-MRAM), for example. In one or more embodiments, the storage device 404 can include non-transitory computer readable media having instructions thereon that, when executed by one or more processing devices (e.g., the processor 402), cause the computing device 400 to perform any appropriate ones of or portions of the methods disclosed herein.

The computing device 400 can include an interface device 406 (e.g., one or more interface devices 406). The interface device 406 can include one or more communication chips, connectors, and/or other hardware and software to govern communications between the computing device 400 and other computing devices. For example, the interface device 406 can include circuitry for managing wireless communications for the transfer of data to and from the computing device 400. The term "wireless" and its derivatives can be used to describe circuits, devices, systems, methods, techniques, communications channels, etc., that can communicate data through the use of modulated electromagnetic radiation through a nonsolid medium. The term does not imply that the associated devices do not contain any wires, although in one or more embodiments the associated devices might not contain any wires. Circuitry included in the interface device 406 for managing wireless communications can implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). In one or more embodiments, circuitry included in the interface device 406 for managing wireless communications can operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. In one or more embodiments, circuitry included in the interface device 406 for managing wireless communications can operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). In one or more embodiments, circuitry included in the interface device 406 for managing wireless communications can operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. In one or more embodiments, the interface device 406 can include one or more antennas (e.g., one or more antenna arrays) to receipt and/or transmission of wireless communications.

In one or more embodiments, the interface device 406 can include circuitry for managing wired communications, such as electrical, optical, or any other suitable communication protocols. For example, the interface device 406 can include circuitry to support communications in accordance with Ethernet technologies. In one or more embodiments, the interface device 406 can support both wireless and wired communication, and/or can support multiple wired communication protocols and/or multiple wireless communication protocols. For example, a first set of circuitry of the interface device 406 can be dedicated to shorter-range wireless communications such as Wi-Fi or Bluetooth, and a second set of circuitry of the interface device 406 can be dedicated to longer-range wireless communications such as global positioning system (GPS), EDGE, GPRS, CDMA, WiMAX, LTE, EV-DO, or others. In one or more embodiments, a first set of circuitry of the interface device 406 can be dedicated to wireless communications, and a second set of circuitry of the interface device 406 can be dedicated to wired communications.

The computing device 400 can include battery/power circuitry 408. The battery/power circuitry 408 can include one or more energy storage devices (e.g., batteries or capacitors) and/or circuitry for coupling components of the computing device 400 to an energy source separate from the computing device 400 (e.g., AC line power).

The computing device 400 can include a display device 410 (e.g., multiple display devices). The display device 410 can include any visual indicators, such as a heads-up display, a computer monitor, a projector, a touchscreen display, a liquid crystal display (LCD), a light-emitting diode display, or a flat panel display.

The computing device 400 can include other input/output (I/O) devices 412. The other I/O devices 412 can include one or more audio output devices (e.g., speakers, headsets, earbuds, alarms, etc.), one or more audio input devices (e.g., microphones or microphone arrays), location devices (e.g., GPS devices in communication with a satellite-based system to receive a location of the computing device 400, as known in the art), audio codecs, video codecs, printers, sensors (e.g., thermocouples or other temperature sensors, humidity sensors, pressure sensors, vibration sensors, accelerometers, gyroscopes, etc.), image capture devices such as cameras, keyboards, cursor control devices such as a mouse, a stylus, a trackball, or a touchpad, bar code readers, Quick Response (QR) code readers, or radio frequency identification (RFID) readers, for example.

The computing device 400 can have any suitable form factor for its application and setting, such as a handheld or mobile computing device (e.g., a cell phone, a smart phone, a mobile internet device, a tablet computer, a laptop computer, a netbook computer, an ultrabook computer, a personal digital assistant (PDA), an ultra mobile personal computer, etc.), a desktop computing device, or a server computing device or other networked computing component.

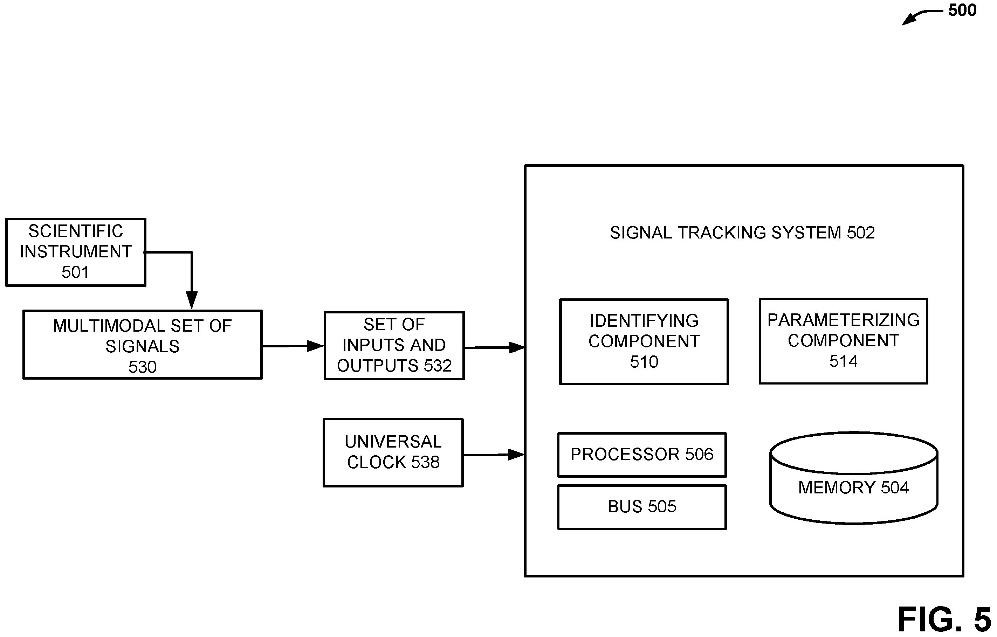

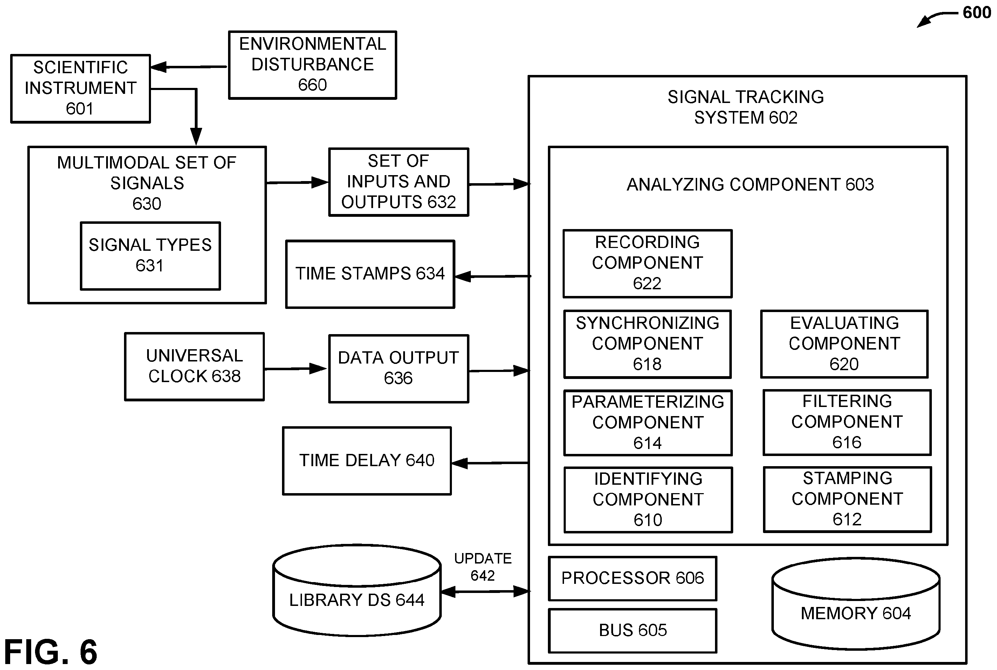

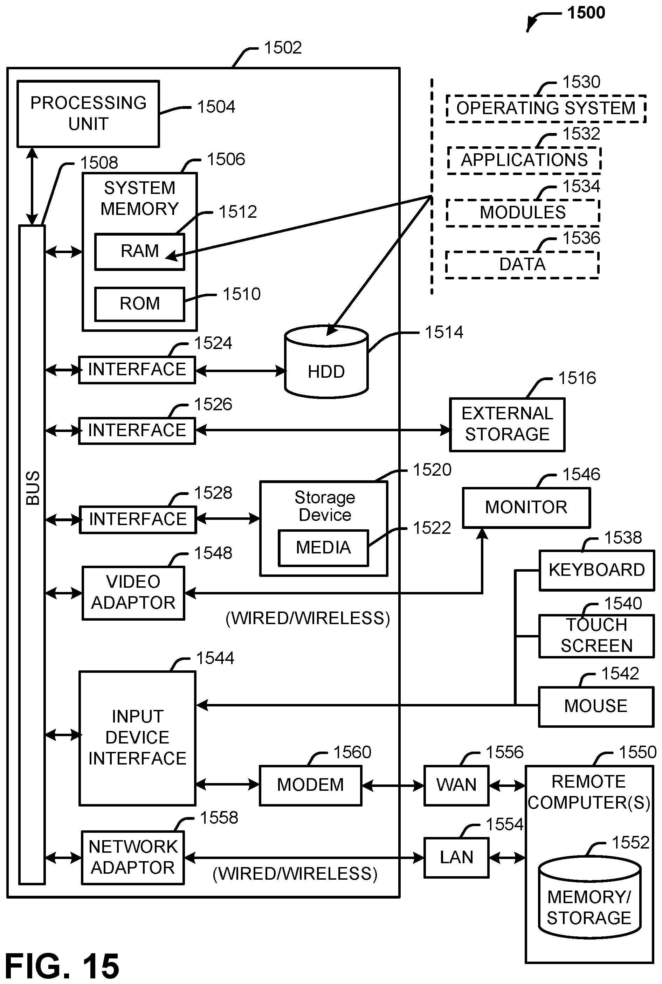

Referring now to FIGS. 5 and 6, in one or more embodiments, the non-limiting systems 500 and/or 600 illustrated at FIGS. 5 and 6, and/or systems thereof, can further comprise one or more computer and/or computing-based elements described herein with reference to a computing environment, such as the computing environment 1500 illustrated at FIG. 15. In one or more described embodiments, computer and/or computing-based elements can be used in connection with implementing one or more of the systems, devices, components and/or computer-implemented operations shown and/or described in connection with FIGS. 5 and/or 6 and/or with other figures described herein.

Turning first to FIG. 5, the figure illustrates a block diagram of an example, non-limiting system 500 that can comprise a signal tracking system 502. The signal tracking system 502 can generally facilitate synchronization and tracking of multimodal signals, such as associated with a scientific instrument.

In one or more embodiments, the signal tracking system 502 can be at least partially comprised by the computing device 400.

It is noted that the signal tracking system 502 is only briefly detailed to provide but a lead-in to a more complex and/or more expansive signal tracking system 602 as illustrated at FIG. 6. That is, further detail regarding processes that can be performed by one or more embodiments described herein will be provided below relative to the non-limiting system 600 of FIG. 6.

Still referring to FIG. 5, the signal tracking system 502 can comprise at least a memory 504, bus 505, processor 506, identifying component 510 and/or parameterizing component 514. The processor 506 can be the same as the processor 402, comprised by the processor 402 or different therefrom. The memory 504 can be the same as the storage device 404, comprised by the storage device 404 or different therefrom.

Using the above-noted components, the signal tracking system 502 can facilitate a process to track multimodal signals that have been acquired relative to a scientific instrument 501.

Generally, the identifying component 510 can identify a multimodal set of signals 530, and further can identify a set of inputs and outputs 532 corresponding to, comprised by, and/or generated from data/metadata of the multimodal set of signals 530. The set of signals 530 can have been acquired, such as by the signal tracking system 502 and/or by a scientific instrument 501. The set of signals 530 can have been output by the scientific instrument 501 or by another scientific instrument 501. For example, a scientific instrument 501 that can output a multimodal set of signals 530 can be an imaging device, such as a charged particle device.

Put another way, the identifying component 510 can generally identify a set of inputs and outputs 532 of a scientific instrument 501.

The identifying component 510 can generally determine whether each signal type of the multimodal set of signals 530 has been identified for being synchronized to one another. That is, the identifying component 510 can compare and contrast the set of signals 530 relative to one another to determine differences therebetween, such as to determine individual types of a set of multimodal types of the multimodal set of signals 530.

Further, the parameterizing component 514 can generally track the inputs and outputs 532 of the set 532 based on a universal clock 538 common to the inputs and outputs of the set 532. That is, the parameterizing component 514 can perform one or more processes to analyze the inputs and outputs of the set 532 according to a synchronization (e.g., time stamps and/or other parameters) applied to the inputs and outputs of the set 532 to allow for linking and/or correlations among the set of signals 530.

As a result of these components, the various multimodal signals 530 can be compared to one another to determine how plural signals, for example, affected an event occurring at one or more signals. Such event can be based on varying types of signals, position of a sample, energy applied to a sample, etc.

The identifying component 510 and/or parameterizing component 514 can be operatively coupled to the processor 506 which can be operatively coupled to the memory 504. The bus 505 can provide for the operative coupling. The processor 506 can facilitate execution of the identifying component 510 and/or parameterizing component 514. The identifying component 510 and/or parameterizing component 514 can be stored at the memory 504.

In general, the non-limiting system 500 can employ any suitable method of communication (e.g., electronic, communicative, internet, infrared, fiber, etc.) to provide communication between the signal tracking system 502, a library datastore, and/or any device associated with a user entity.

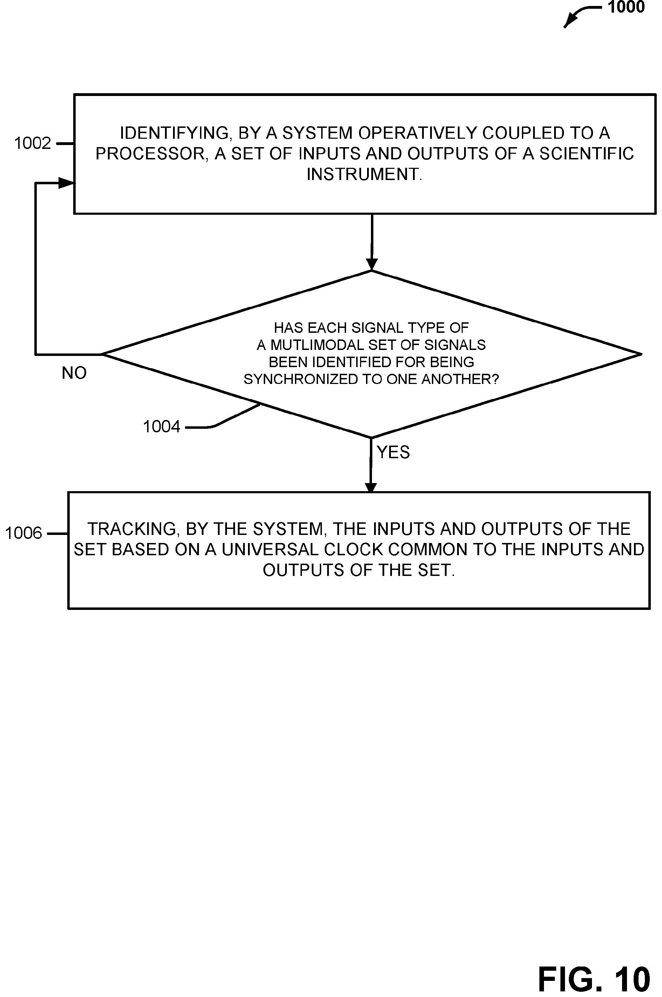

As a summary of the above-described components and functions thereof, referring next only briefly to FIG. 10, illustrated is a flow diagram of an example, non-limiting method 1000 that can facilitate a process for multimodal signal tracking. While the non-limiting method 1000 is described relative to the non-limiting system 500 of FIG. 5, the non-limiting method 1000 can be applicable also to other systems described herein, such as the non-limiting system 600 of FIG. 6. Repetitive description of like elements and/or processes employed in respective embodiments is omitted for sake of brevity.

At 1002, the non-limiting method 1000 can comprise identifying, by the system (e.g., identifying component 510), operatively coupled to a processor, a set of inputs and outputs (e.g., set of inputs and outputs 532) of a scientific instrument (e.g., scientific instrument 501).

At 1004, the non-limiting method 1000 can comprise determining, by the system (e.g., identifying component 510), whether each signal type of a multimodal set of signals (e.g., multimodal set of signals 530) has been identified for being synchronized to one another. If not, the non-limiting method 1000 can proceed back to step 1002. If yes, the non-limiting method can proceed forward to step 1006.

At 1006, the non-limiting method 1000 can comprise tracking, by the system (e.g., parameterizing component 516), the inputs and outputs of the set based on a universal clock (e.g., universal clock 538) common to the inputs and outputs of the set.

Turning next to FIG. 6, a non-limiting system 600 is illustrated that can comprise a signal tracking system 602, a scientific instrument 601, and a library datastore (DS) 644. Repetitive description of like elements and/or processes employed in respective embodiments is omitted for sake of brevity. Description relative to an embodiment of FIG. 5 can be applicable to an embodiment of FIG. 6. Likewise, description relative to an embodiment of FIG. 6 can be applicable to an embodiment of FIG. 5.

Generally, the signal tracking system 602 can facilitate a process to track multimodal signals 630 that have been acquired relative to the scientific instrument 601.

In one or more embodiments, the signal tracking system 602 can be at least partially comprised by the computing device 400.

One or more communications between one or more components of the non-limiting system 600 can be provided by wired and/or wireless means including, but not limited to, employing a cellular network, a wide area network (WAN) (e.g., the Internet), and/or a local area network (LAN). Suitable wired or wireless technologies for supporting the communications can include, without being limited to, wireless fidelity (Wi-Fi), global system for mobile communications (GSM), universal mobile telecommunications system (UMTS), worldwide interoperability for microwave access (WiMAX), enhanced general packet radio service (enhanced GPRS), third generation partnership project (3GPP) long term evolution (LTE), third generation partnership project 2 (3GPP2) ultra-mobile broadband (UMB), high speed packet access (HSPA), Zigbee and other 802.XX wireless technologies and/or legacy telecommunication technologies, BLUETOOTH^{®}, Session Initiation Protocol (SIP), ZIGBEE^{®}, RF4CE protocol, WirelessHART protocol, 6LoWPAN (Ipv6 over Low power Wireless Area Networks), Z-Wave, an advanced and/or adaptive network technology (ANT), an ultra-wideband (UWB) standard protocol and/or other proprietary and/or non-proprietary communication protocols.

The signal tracking system 602 can be associated with, such as accessible via, a cloud computing environment, such as the cloud computing environment 1500 of FIG. 15.

The signal tracking system 602 can comprise a plurality of components. The components can comprise a memory 604, processor 606, bus 605, identifying component 610, stamping component 612, parameterizing component 614, filtering component 616, synchronizing component 618, evaluating component 620 and/or recording component 622. Using these components, the signal tracking system 602 can facilitate a process to track multimodal signals 630 that have been acquired relative to the scientific instrument 601, such as by generally synchronizing the multimodal signals 630 relative to a common universal clock 638.

Discussion next turns to the processor 606, memory 604 and bus 605 of the signal tracking system 602. For example, in one or more embodiments, the signal tracking system 602 can comprise the processor 606 (e.g., computer processing unit, microprocessor, classical processor, and/or like processor). In one or more embodiments, a component associated with signal tracking system 602, as described herein with or without reference to the one or more figures of the one or more embodiments, can comprise one or more computer and/or machine readable, writable and/or executable components and/or instructions that can be executed by processor 606 to provide performance of one or more processes defined by such component and/or instruction. In one or more embodiments, the processor 606 can comprise the identifying component 610, stamping component 612, parameterizing component 614, filtering component 616, synchronizing component 618, evaluating component 620 and/or recording component 622.

In one or more embodiments, the signal tracking system 602 can comprise the computer-readable memory 604 that can be operably connected to the processor 606. The memory 604 can store computer-executable instructions that, upon execution by the processor 606, can cause the processor 606 and/or one or more other components of the signal tracking system 602 (e.g., identifying component 610, stamping component 612, parameterizing component 614, filtering component 616, synchronizing component 618, evaluating component 620 and/or recording component 622) to perform one or more actions. In one or more embodiments, the memory 604 can store computer-executable components (e.g., identifying component 610, stamping component 612, parameterizing component 614, filtering component 616, synchronizing component 618, evaluating component 620 and/or recording component 622).

The signal tracking system 602 and/or a component thereof as described herein, can be communicatively, electrically, operatively, optically and/or otherwise coupled to one another via a bus 605. Bus 605 can comprise one or more of a memory bus, memory controller, peripheral bus, external bus, local bus, and/or another type of bus that can employ one or more bus architectures. One or more of these examples of bus 605 can be employed.

In one or more embodiments, the signal tracking system 602 can be coupled (e.g., communicatively, electrically, operatively, optically and/or like function) to one or more external systems (e.g., a non-illustrated electrical output production system, one or more output targets and/or an output target controller), sources and/or devices (e.g., computing devices, communication devices and/or like devices), such as via a network. In one or more embodiments, one or more of the components of the signal tracking system 602 and/or of the non-limiting system 600 can reside in the cloud, and/or can reside locally in a local computing environment (e.g., at a specified location).

In addition to the processor 606 and/or memory 604 described above, the signal tracking system 602 can comprise one or more computer and/or machine readable, writable and/or executable components and/or instructions that, when executed by processor 606, can provide performance of one or more operations defined by such component and/or instruction.

Discussion next turns to the additional components of the signal tracking system 602 (e.g., identifying component 610, stamping component 612, parameterizing component 614, filtering component 616, synchronizing component 618, evaluating component 620 and/or recording component 622). Generally, the signal tracking system 602 can perform a set of processes that can be separated into various steps comprising, but not limited to: identification of a set of inputs and outputs 632, time stamping of the inputs and outputs 632, tracking of the inputs and outputs 632, which tracking can comprise interference filtering, recording, evaluating, analyzing, identifying a time delay, etc., and synchronizing the universal clock 638 with another clock associated with one or more inputs and outputs of the set of inputs and outputs 632.

First, it is noted that in one or more embodiments, the identifying component 610, stamping component 612, parameterizing component 614, filtering component 616, synchronizing component 618, evaluating component 620 and/or recording component 622 can be implemented independently, without one or more other of the identifying component 610, stamping component 612, parameterizing component 614, filtering component 616, synchronizing component 618, evaluating component 620 and/or recording component 622. Additionally and/or alternatively, the identifying component 610, stamping component 612, parameterizing component 614, filtering component 616, synchronizing component 618, evaluating component 620 and/or recording component 622 can be comprised by a high-level analyzing component 603, one or more of the below-described functions of the identifying component 610, stamping component 612, parameterizing component 614, filtering component 616, synchronizing component 618, evaluating component 620 and/or recording component 622 can be performed by the high-level analyzing component 603, and/or the identifying component 610, stamping component 612, parameterizing component 614, filtering component 616, synchronizing component 618, evaluating component 620 and/or recording component 622 can be omitted with the high-level analyzing component 603 performing one or more of the below-described functions of the one or more omitted identifying component 610, stamping component 612, parameterizing component 614, filtering component 616, synchronizing component 618, evaluating component 620 and/or recording component 622.

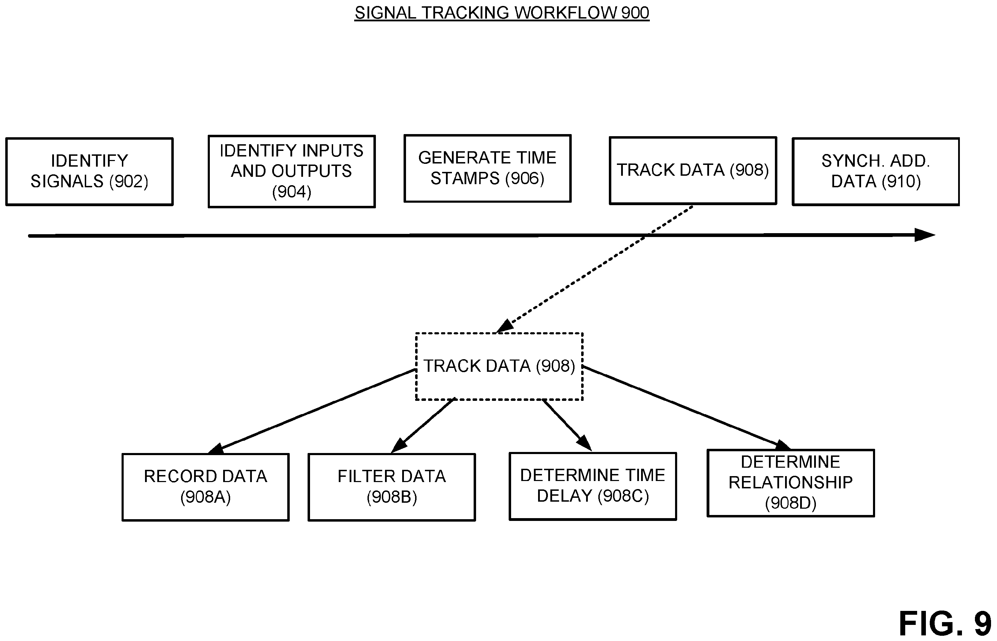

Turning first to the identifying component 610, this component can generally identify a multimodal set of signals 630, and further can identify a set of inputs and outputs 632 corresponding to, comprised by, and/or generated from data/metadata of the multimodal set of signals 630. Looking briefly to FIG. 9, in addition still to FIG. 6, step 902 and step 904 can be performed by the identifying component 610.

The set of signals 630 can have been acquired, such as by the signal tracking system 602 and/or by a scientific instrument 601. The set of signals 630 can have been output by the scientific instrument 601 or by another scientific instrument 601. For example, a scientific instrument 601 that can output a multimodal set of signals 630 can be an imaging device, such as a charged particle device, scanning electron microscope (SEM), scanning transmission electron microscope (STEM), etc.

Put another way, the identifying component 610 can generally identify a set of inputs and outputs 632 of a charged particle device 601. More particularly, the identifying component 610 can scan one or more frequencies, communications, signal paths, communication packets, action logs, etc. corresponding to the scientific instrument 601 to identify the multimodal set of signals 630, which signals can comprise the set of inputs and outputs 632. Determination between inputs of the set 632 and outputs of the set 632 can be based on tracking, by the identifying component 610, origination of a signal of the set 630 (e.g., whether the signal was originated by/transmitted by the scientific instrument 601 or was received/obtained by the scientific instrument 601, for example).

In one or more embodiments, the identifying component 610 can generally determine whether each signal type of the multimodal set of signals 630 has been identified for being synchronized to one another. That is, the identifying component 610 can compare and contrast the signals of the set of signals 630 relative to one another to determine differences therebetween, such as to determine individual types of a set of multimodal types of the multimodal set of signals 630.

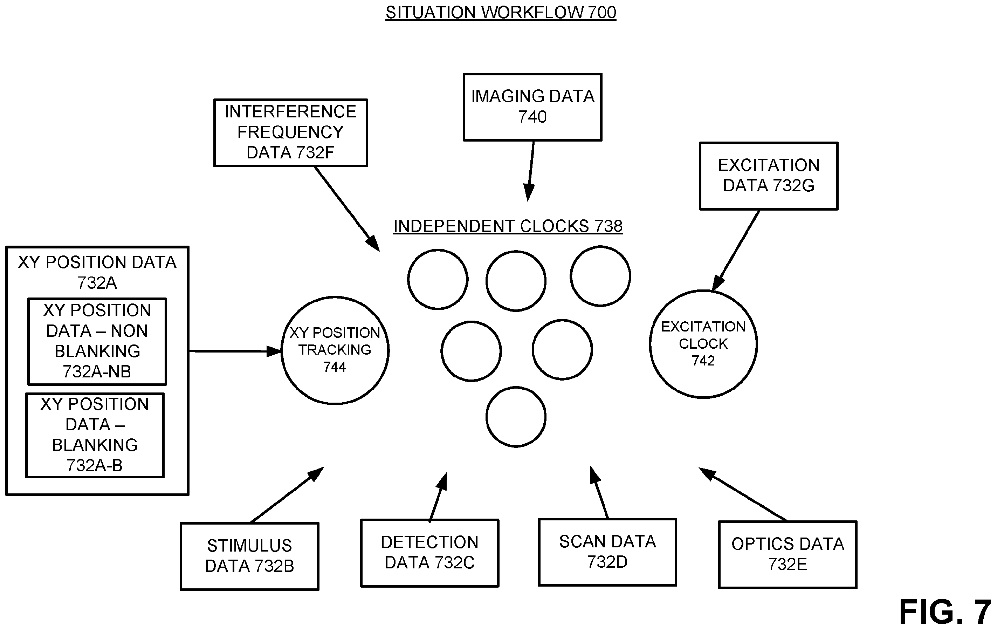

For example, turning briefly to FIG. 7, one or more signal types are illustrated, without being limited thereto. More or fewer signal types than listed at the situation workflow 700 can be employed by a scientific instrument 601 and thus identified by the identifying component 610. Examples can comprise interference frequency data 732F (to be described below), imaging data 740, excitation data 732G, XY position data 732A, stimulus data 732B, detection data 732C, scan data 732D and/or optics data 732E, among others. As illustrated each can employ an individual tracking method, such as independent clocks 732, an excitation clock 742 and/or XY position tracking 744. As a result, linking and/or synchronizing amongst the different data types (e.g., corresponding to respective signal types) can be difficult if not impossible. This can lead to difficulty in comprehending an event having taking place during an experiment. For example, this can lead to difficulty by an artificial intelligence to correlate various data resulting from an experiment to one another.

Referring again to FIGS. 6 and 9, the stamping component 612 generally can generate one or more time stamps 634 for the inputs and outputs, based on data output from a universal clock 638, where the time stamps 634 are not affected by a change in an XY position output of the outputs (set 632). That is, at step 906, the stamping component 612 can determine data output 636 from the universal clock 638. Based thereon, the stamping component 612 can compare serial counting of the universal clock 638 to metadata of the inputs and outputs of the set of inputs and outputs 632. Based on the comparison, the stamping component 612 can generate metadata defining a time stamp 634 for each point of data of the set 632 that has been acquired (e.g., identified by the identifying component 610).

In one or more embodiments, this generating and applying of a time stamp 634 can be executed dynamically, such as in parallel with and/or close to acquiring of data of a signal by the identifying component 610. In one or more other embodiments, this generating and applying of a time stamp 634 can be applied some time after obtaining the data, such as after an experiment has commenced. Regardless, metadata associated with the inputs and outputs of a set 632 can be employed to compare the input and/or output to data output 636 of a universal clock 638. This can include comparing XY position tracking 744 along a timeline of the universal clock 638.

In one or more embodiments, a time stamp 634 can be stored at the memory 604, library datastore 644 and/or any other suitable location communicatively accessible to the signal tracking system 602.

Turning briefly to the universal clock 638, such clock can be a component of the processor 606 or of any other processor communicatively accessible to the signal tracking system 602. The universal clock 638 can provide continuous (e.g., serial) counting of time in any suitable unit increments.

At step 908, the parameterizing component 614 can generally track the inputs and outputs 632 of the set 632 based on the universal clock 638 common to the inputs and outputs of the set 632. That is, a single universal clock 638, and thus a single timing can be employed for the multimodal set of signals 630, and thus for the set of inputs and outputs 632 comprised by the multimodal set of signals 630.

Based thereon, the parameterizing component 614 can perform one or more processes to analyze the inputs and outputs of the set 632 according to a synchronization (e.g., time stamps and/or other parameters) applied to the inputs and outputs of the set 632 to allow for linking and/or correlations among the set of signals 630.

This tracking can comprise interference filtering, recording, evaluating, analyzing, identifying a time delay, etc., without being limited thereto

It is appreciated that based at least on the processes performed by the stamping component 612 and parameterizing component 614, the universal clock 638 can be employed absent any adjustment of the universal clock 638 (e.g., absent any adjustment of any clock for tracking the signal set 630) that is based on an environmental disturbance 660 to the scientific instrument. For example, an environmental disturbance 660 can cause variance, drift, stoppage, and/or jump in signal output and/or input to an experiment. In one example, an environmental disturbance 660 can cause a vibration, bump, etc. of an XY position, thus causing variance in XY position output (of the set of inputs and outputs 632). Such variance can thus be likewise appropriated in the XY position tracking 744. For another example, experiment output can be used to find within an energy axis instability an interference frequency of the environment, which understanding can be applied to correct one or more instabilities in the XY positions or vice versa.

Absent use of the one or more embodiments described herein, invariance of timing of a clock can be difficult to compare and/or incomparable to a variable XY position tracking 744. For example, the timing accuracy can go up to femtosecond precision or to attosecond precision in ultrafast experiments with cavity or laser excitation of the illumination, such as in an embodiment with multiple clocks phase shifts between the tracking can occur, which multiple clocks phase shifts can be undesirably difficult to compensate afterwards. Indeed, it can be time consuming when multiple input/output clocks are to be synchronized after an experiment, and it can be undesirably difficult or impossible to process live data in an existing case where a universal time stamping is not happening online. That is, for an experiment, scanning speeds can be in the order of nanoseconds per pixel, which can require nanosecond precision of XY position tracking synchronized with the input/output signals.

Differently, based on the one or more processes of the stamping component 612 and/or parameterizing component 614 employing the timing of the universal clock 638, an ordering parameter (e.g., time corresponding to the universal clock 638) can be employed which is not altered by environmental disturbances 660 like the conventional XY position tracking 744. This can be because time is invariant while the XY position tracking 744 can be variable due to instabilities, such as physical instabilities.

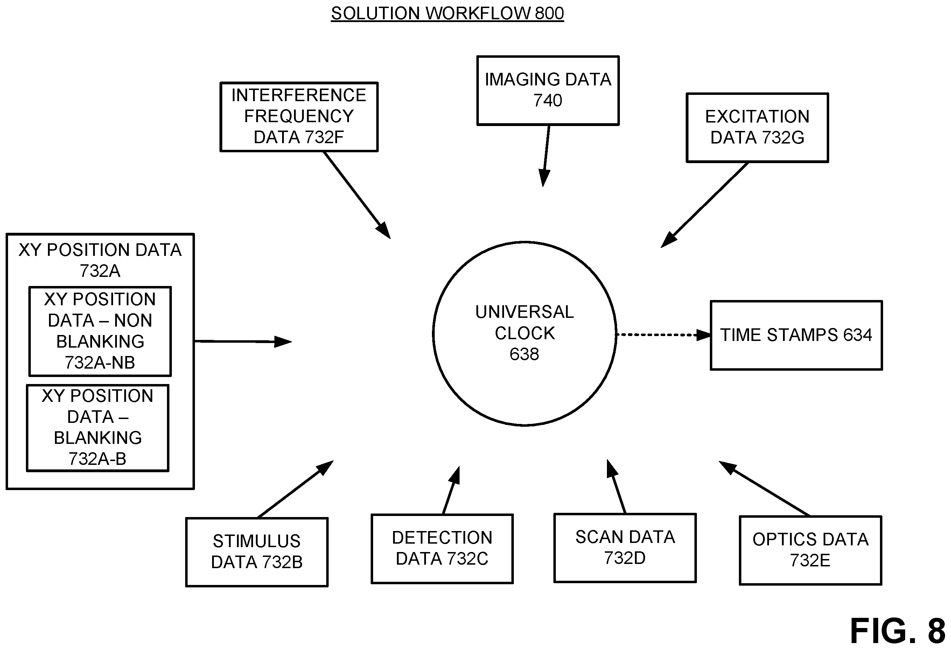

For example, turning briefly to FIG. 8, as illustrated at the solution workflow 800, each of the varying data types (corresponding to respective signal types) can employ a single and common tracking method based on the universal clock 638.

Referring again to FIGS. 6 and 9, based on direction (e.g., communication, signal, etc.) from the parameterizing component 614, various additional components of the signal tracking system 602 can perform various respective processes 908A-908D.

For example, at step 908B, the filtering component 616 can filter out an interference frequency output 732F, of the outputs 632, that is affecting imaging outputs 740, of the outputs 632. This can be accomplished by scanning for an interference frequency, corresponding to the interference frequency output 732F, according to the universal clock 638. Such process cannot be performed using existing frameworks due to lack of synchronization between different signal types acquired from a scientific instrument 601.

For another example, at step 908C, the evaluating component 620 can identify a time delay 640 between different combinations of inputs, outputs or both, of the inputs and outputs of the set 632, according to the universal clock 638. That is, a gap in data can be associated with a first signal of the set 630, but not with other signals of the set 630. This gap can be accounted for based on the processes performed by the stamping component 612 and/or parameterizing component 614. Such process cannot be performed using existing frameworks due to lack of synchronization between different signal types acquired from a scientific instrument 601.

For another example, at step 908A, the recording component 622 can record a set of XY position outputs 732A-NB, of the outputs 632, from the scientific instrument 601, where the recording component 622 omits recording of XY position outputs 732A-B corresponding to beam blanking. That is, when using a fast beam blanker during a scan by a scientific instrument 601, a sparse XY pattern can be generated. Conventionally, all empty XY positions are recorded. By using the timing of the universal clock 638 as the reference only when the beam is unblanked, only such unblanked-related signals/data (e.g., XY position outputs 732A-NB) can be recorded. This can lead to a significant reduction in bandwidth, power, time, storage space, memory and/or data employed due to omission of recording of conversely respective blanked-related signals/data (e.g., XY position outputs 732A-B). Such process cannot be performed using existing frameworks due to lack of synchronization between different signal types acquired from a scientific instrument 601.

Recording by the recording component 622 can comprise a write action (e.g., comprising an update 642) or any other suitable action to a suitable storage, such as the library datastore (DS) 644.

For another example, at step 908D, various comparisons between/among signal types 631, as not particularly defined herein, can be performed. That is, processes and/or results of use of the signal tracking system 602 are not limited only to those explicitly described herein.

Further, at step 910, based on the data output 636 of the universal clock 638, the synchronizing component 618 can determine a second timing of an excitation clock 742 employed for dynamic excitation by a scientific instrument 601. The synchronizing component 618 can correspondingly synchronize a first timing of the universal clock 638 to the second timing of the excitation clock 742, or vice versa.

For example, in dynamic experiments, a time zero can be defined at a point in time at which an excitation is applied. A response corresponding to the sample can be measured in time for decay time experiments in a non-reversive experiment. In a stroboscopic set-up, a periodic pulsed illumination can be synchronized with a periodic excitation of the sample to monitor a reversible process. A phase shift between the two weak signals can be summed (e.g., in an ultrafast experiment) and a time response can be measured by varying the phase shift between excitation and illumination. In one or more cases, the phase shift can be detected by using a time resolved detector by time stamping the sample excitation event and the detection of the signal on the sensor. Differently, existing frameworks employ only pulsing the beam in a single shot or a stroboscopic excitation synchronized with the time of excitation of the sample. On the other hand, the one or more embodiments described herein can provide for synchronizing of the beam scan, source, and detection event at the same time with the excitation time of the sample.

Indeed, in one or more other embodiments, a universal clock 638 can be set based on (e.g., in parallel with) corresponding output data of any other independent clock 738.

As a result of the various component 610-622 discussed above, the various multimodal signals 630 can be compared to one another to determine how plural signals, for example, can have affected an event occurring at/defined by one or more signals. Such event can be based on varying types 631 of signals, XY position 732A of a sample, energy applied to a sample, etc.

In one or more embodiments, artificial intelligence (AI) analysis can be employed to determine compensation of artifacts resulting from an experiment at a scientific instrument 601, which determination can be made possible since time reference is always undisturbed (e.g., invariant).

In one or more embodiments, based on the one or more embodiments described herein, one or more experiment types can be performed that cannot be performed using existing frameworks. For example, coincidence measurement and/or critical dose measurements can benefit from signal comparison provided by use of a common universal clock 638 and lack of signal tracking loss (e.g., from use of XY position 732A to track serially obtained signals, as in existing frameworks). For another example, such new experiments can comprise easy integration of new dynamic third-party components like holders, lasers, and/or fast detectors based on the processes described above as can be performed by at least the identifying component 610, stamping component 612 and parameterizing component 614.

As further, additional and/or alternative result of use of one or more embodiments described herein one or more of the following benefits can be provided, without being limited thereto: easy and reproduceable set-up of dynamic experiment workflows, accurate event documentation for offline analysis, time resolution increase up to nanoseconds, increased accuracy in correlation of multimodal data via time stamping, and/or increased drift correction accuracy in dynamic experiments via fastest scan speed.

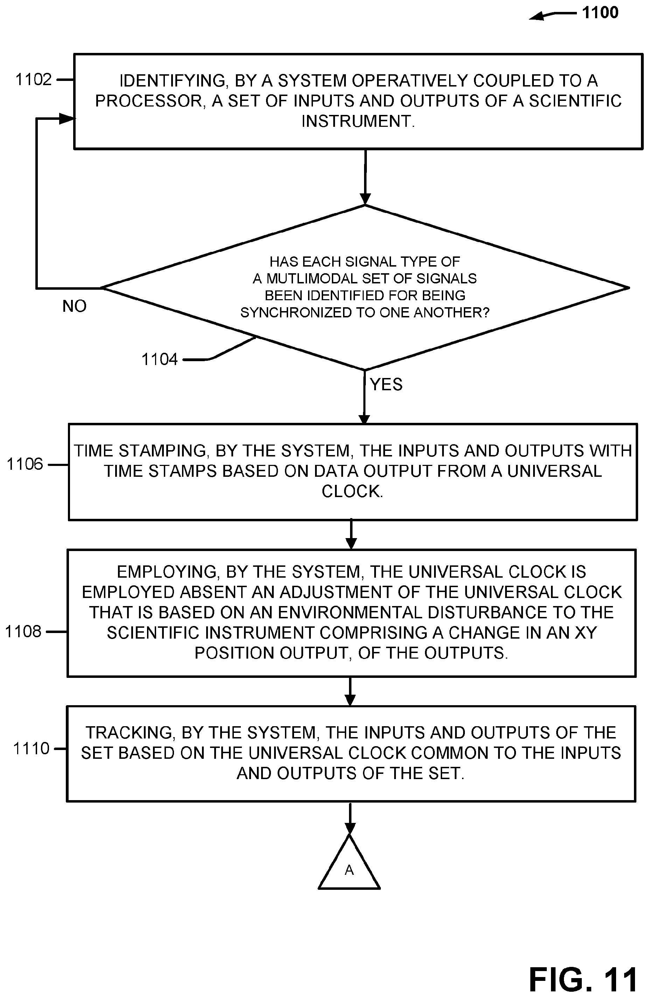

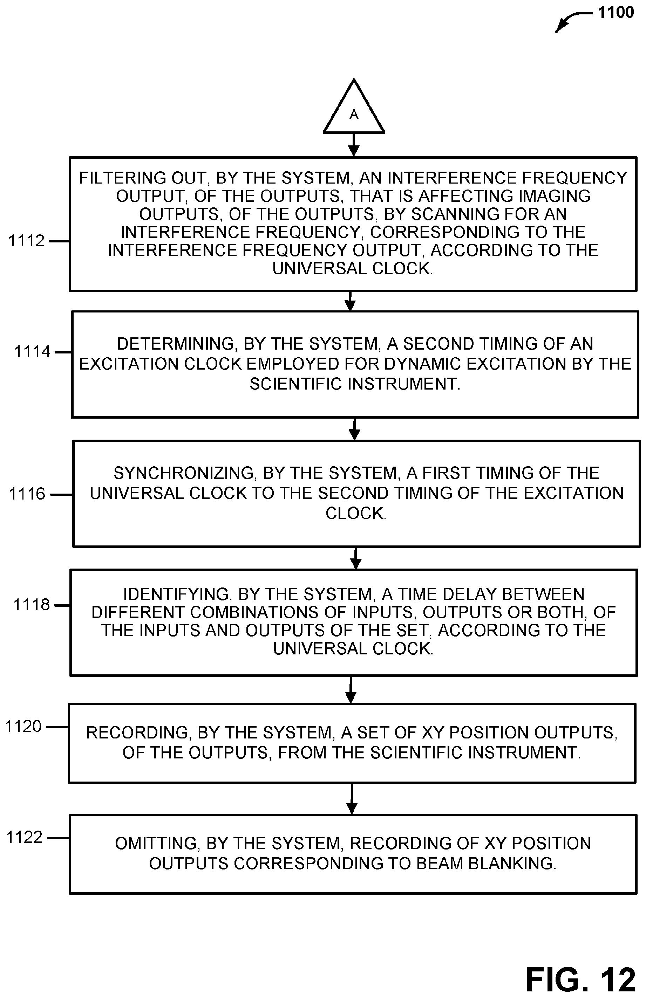

As a summary of the above-described components and/or functions thereof, referring next to FIGS. 11 and 12, illustrated is a flow diagram of an example, non-limiting method 1100 that can facilitate a process for multimodal signal tracking, in accordance with one or more embodiments described herein, such as the non-limiting system 600 of FIG. 6. While the non-limiting method 1100 is described relative to the non-limiting system 600 of FIG. 6, the non-limiting method 1100 can be applicable also to other systems described herein, such as the non-limiting system 500 of FIG. 5. Repetitive description of like elements and/or processes employed in respective embodiments is omitted for sake of brevity.

At 1102, the non-limiting method 1100 can comprise identifying, by a system (e.g., identifying component 610) a set of inputs and outputs (e.g., set of inputs and outputs 632) of a scientific instrument (e.g., scientific instrument 601).

At 1104, the non-limiting method 1100 can comprise determining, by the system (e.g., identifying component 610), whether each signal type (e.g., signal types 631) of a multimodal set of signals (e.g., multimodal set of signals 630) has been identified for being synchronized to one another. If not, the non-limiting method 1100 can proceed back to step 1102. If yes, the non-limiting method can proceed forward to step 1106.

At 1106, the non-limiting method 1100 can comprise time stamping, by the system (e.g., stamping component 612), the inputs and outputs with time stamps (e.g., time stamps 634) based on data output (e.g., data output 636) from a universal clock (e.g., universal clock 638).

At 1108, the non-limiting method 1100 can comprise employing, by the system (e.g., stamping component 612) the universal clock is employed absent an adjustment of the universal clock that is based on an environmental disturbance (e.g., environmental disturbance 660) to the scientific instrument comprising a change in an XY position output (e.g., XY position output 732A), of the outputs.

At 1110, the non-limiting method 1100 can comprise tracking, by the system (e.g., parameterizing component 614), the inputs and outputs of the set based on the universal clock common to the inputs and outputs of the set.

At 1112, the non-limiting method 1100 can comprise filtering out, by the system (e.g., filtering component 616), an interference frequency output (e.g., interference frequency output 732F), of the outputs, that is affecting imaging outputs (e.g., imaging outputs 740), of the outputs, by scanning for an interference frequency, corresponding to the interference frequency output, according to the universal clock.

At 1114, the non-limiting method 1100 can comprise determining, by the system (e.g., synchronizing component 618), a second timing of an excitation clock (e.g., excitation clock 742) employed for dynamic excitation by the scientific instrument.

At 1116, the non-limiting method 1100 can comprise synchronizing, by the system (e.g., synchronizing component 618), a first timing of the universal clock to the second timing of the excitation clock.

At 1118, the non-limiting method 1100 can comprise identifying, by the system (e.g., evaluating component 620), a time delay (e.g., time delay 640) between different combinations of inputs, outputs or both, of the inputs and outputs of the set, according to the universal clock.

At 1120, the non-limiting method 1100 can comprise recording, by the system (e.g., recording component 622), a set of XY position outputs, of the outputs, from the scientific instrument.

At 1122, the non-limiting method 1100 can comprise omitting, by the system (e.g., recording component 622), recording of XY position outputs corresponding to beam blanking (e.g., XY position outputs 732A-B).

### Additional Summary

For simplicity of explanation, the computer-implemented and non-computer-implemented methodologies provided herein are depicted and/or described as a series of acts. It is to be understood that the subject innovation is not limited by the acts illustrated and/or by the order of acts, for example acts can occur in one or more orders and/or concurrently, and with other acts not presented and described herein. Furthermore, not all illustrated acts can be utilized to implement the computer-implemented and non-computer-implemented methodologies in accordance with the described subject matter. In addition, the computer-implemented and non-computer-implemented methodologies could alternatively be represented as a series of interrelated states via a state diagram or events. Additionally, the computer-implemented methodologies described hereinafter and throughout this specification are capable of being stored on an article of manufacture for transporting and transferring the computer-implemented methodologies to computers. The term article of manufacture, as used herein, is intended to encompass a computer program accessible from any computer-readable device or storage media.

The systems and/or devices have been (and/or will be further) described herein with respect to interaction between one or more components. Such systems and/or components can include those components or sub-components specified therein, one or more of the specified components and/or sub-components, and/or additional components. Sub-components can be implemented as components communicatively coupled to other components rather than included within parent components. One or more components and/or sub-components can be combined into a single component providing aggregate functionality. The components can interact with one or more other components not specifically described herein for the sake of brevity, but known by those of skill in the art.

In summary, one or more systems, computer program products and/or computer-implemented methods provided herein relate to a process for multimodal signal acquisition, such as from a charged particle device or other scientific instrument, based on universal clock synchronization of the various multimodal signals. A system can comprise a memory that stores computer executable components; and a processor that executes the computer executable components stored in the memory, wherein the computer executable components comprise an identifying component that identifies a set of inputs and outputs of a scientific instrument, and a parameterizing component that tracks the inputs and outputs of the set based on a universal clock common to the inputs and outputs of the set.

The one or more embodiments described herein can employ a novel system that can be employed with varying (e.g., multimodal) signal types comprising, but not limited to, stimulus, detection, scan, optics, magnetic, electric phase transition and/or dynamic excitation. Each of these signal types can employ the universal clock, thus allowing for inputs and/or outputs of these signal types to be tracked and analyzed relative to one another absent loss of data, time conversion, etc. Further, environmental disturbances, such as causing a change in an XY position due to a physical instability, bump, vibration, etc., do not alter the universal clock because such clock is not based on XY position alone.

Indeed, in view of the one or more embodiments described herein, a practical application of the one or more systems, computer-implemented methods and/or computer program products described herein can be ability to easily order parameters based on multimodal signal acquisition relative to one another, thus allowing for identification of one or more interference frequencies of the environment disturbing another signal, such as an image output signal, and separating out such one or more interference frequencies. These are useful and practical applications of computers, thus providing enhanced (e.g., improved and/or optimized) compound analysis and/or image analysis output. Overall, such computerized tools can constitute a concrete and tangible technical improvement in the fields of material analysis, and more particularly in material analysis based on multimodal signal acquisition.

Furthermore, one or more embodiments described herein can be employed in a real-world system based on the disclosed teachings. For example, the one or more embodiments described herein can provide parameterizing of various signal inputs and/or outputs of a same experiment, operation and/or process, while allowing for identification of one or more interference frequencies of the environment disturbing another signal, such as an image output signal, and separating out such one or more interference frequencies.

In one or more cases, based on the one or more embodiments described herein, one or more experiment types can be performed that cannot be performed using existing frameworks. For example, coincidence measurement and critical dose measurements can benefit from signal comparison provided by use of a common universal clock and lack of signal tracking loss (e.g., from use of XY position to track serially obtained signals, as in existing frameworks).

In one or more cases, reduced storage space and bandwidth can be employed to store and record signals due to ability to omit recording of XY position outputs corresponding to beam blanking, based on use of the one or more embodiments described herein.

The one or more embodiments described herein can be applied on a plug-and-play basis to various architectures of existing scientific instruments, signal acquisition instruments, and/or the like.

These can be useful processes for varying industries employing material analysis, product manufacturing, quality control and/or the like. The embodiments disclosed herein thus can provide improvements to scientific instrument technology (e.g., improvements in the computer technology supporting such scientific instruments, among other improvements).

Further in one or more cases, the embodiments described herein can be self-improving. Indeed, as a common universal clock is employed, allowing for generation and application of time stamps that can be related to one another absent variance, such as due to environmental influences, comparisons for determining relationships between signals acquired, determination of events based on multimodal signals, and/or the like, such as can be performed by a classical computer and/or by one or more artificial intelligences employing the results of the one or more embodiments described herein, can become more efficient and accurate over time. That is, as signals are acquired and synchronized according to a common universal clock, without use of variable XY position as a synchronizing element, but rather synchronizing XY position along with other inputs and outputs, a larger body of accurate comparative data is generated for use in searches, queries, event determinations, signal comparisons and/other analyses performed relative to the various multimodal signals synchronized one or more embodiments described herein. As such, one or more non-limiting systems described herein, comprising a signal tracking system, as described herein, can be self-improving.

Moreover, the one or more embodiments described herein can achieve a level of scale of operation. For example, two or more different signals can be synchronized and tracked using generation and application of time stamps relative to a same experiment and/or process at least partially at a same time as one another, and/or the same can be performed relative to two or more different experiments and/or processes, at least partially at a same time as one another.

The systems and/or devices have been (and/or will be further) described herein with respect to interaction between one or more components. Such systems and/or components can include those components or sub-components specified therein, one or more of the specified components and/or sub-components, and/or additional components. Sub-components can be implemented as components communicatively coupled to other components rather than included within parent components. One or more components and/or sub-components can be combined into a single component providing aggregate functionality. The components can interact with one or more other components not specifically described herein for the sake of brevity, but known by those of skill in the art.

One or more embodiments described herein can be, in one or more embodiments, inherently and/or inextricably tied to computer technology and cannot be implemented outside of a computing environment. For example, one or more processes performed by one or more embodiments described herein can more efficiently, and even more feasibly, provide program and/or program instruction execution, such as relative to reading, synchronizing and/or stamping digital data corresponding to multimodal signal acquisition. Systems, computer-implemented methods and/or computer program products providing performance of these processes are of great utility in the fields of material analysis and cannot be equally practicably implemented in a sensible way outside of a computing environment.

One or more embodiments described herein can employ hardware and/or software to solve problems that are highly technical, that are not abstract, and that cannot be performed as a set of mental acts by a human. For example, a human, or even thousands of humans, cannot efficiently, accurately and/or effectively read, synchronize and/or stamp digital data corresponding to multimodal signal acquisition, as the one or more embodiments described herein can provide this process. Moreover, neither can the human mind nor a human with pen and paper conduct one or more of these processes, as conducted by one or more embodiments described herein.

In one or more embodiments, one or more of the processes described herein can be performed by one or more specialized computers (e.g., a specialized processing unit, a specialized classical computer, and/or another type of specialized computer) to execute defined tasks related to the one or more technologies describe above. One or more embodiments described herein and/or components thereof can be employed to solve new problems that arise through advancements in technologies mentioned above, employment of cloud computing systems, computer architecture and/or another technology.

One or more embodiments described herein can be fully operational towards performing one or more other functions (e.g., fully powered on, fully executed and/or another function) while also performing one or more of the one or more operations described herein.

To provide additional summary, a listing of embodiments and features thereof is next provided.

A system, comprising: a memory that stores computer executable components; and a processor that executes the computer executable components stored in the memory, wherein the computer executable components comprise: an identifying component that identifies a set of inputs and outputs of a scientific instrument; and a parameterizing component that tracks the inputs and outputs of the set based on a universal clock common to the inputs and outputs of the set.

The system of the preceding paragraph, wherein the inputs and outputs of the set comprise XY position inputs and outputs and detection inputs and outputs.

The system of any preceding paragraph, wherein the computer executable components further comprise: a stamping component that time stamps the inputs and outputs with time stamps based on data output from the universal clock, wherein the time stamps are not affected by a change in an XY position output of the outputs.

The system of any preceding paragraph, wherein the computer executable components further comprise: a filtering component that filters out an interference frequency output, of the outputs, which is affecting imaging outputs, of the outputs, by scanning for an interference frequency, corresponding to the interference frequency output, according to the universal clock.

The system of any preceding paragraph, wherein the computer executable components further comprise: a synchronizing component that determines a second timing of an excitation clock employed for dynamic excitation by the scientific instrument and synchronizes a first timing of the universal clock to the second timing of the excitation clock.

The system of any preceding paragraph, wherein the universal clock is employed absent an adjustment of the universal clock that is based on an environmental disturbance to the scientific instrument comprising a change in an XY position output, of the outputs.

The system of any preceding paragraph, wherein the computer executable components further comprise: an evaluating component that identifies a time delay between different combinations of inputs, outputs or both, of the inputs and outputs of the set, according to the universal clock.

The system of any preceding paragraph, wherein the computer executable components further comprise: a recording component that records a set of XY position outputs, of the outputs, from the charged particle device, wherein the recording component omits recording of XY position outputs corresponding to beam blanking.

A computer-implemented method, comprising: identifying, by a system operatively coupled to a processor, a set of inputs and outputs of a charged particle device; and tracking, by the system, the inputs and outputs of the set based on a universal clock common to the inputs and outputs of the set.

The computer-implemented method of the preceding paragraph, further comprising: generating, by the system, time stamps for the inputs and outputs, based on data output from the universal clock, wherein the time stamps are not affected by a change in an XY position output of the outputs.

The computer-implemented method of any preceding paragraph, further comprising: filtering out, by the system, an interference frequency output, of the outputs, which is affecting imaging outputs, of the outputs, by scanning for an interference frequency, corresponding to the interference frequency output, according to the universal clock.

The computer-implemented method of any preceding paragraph, further comprising: determining, by the system, a first timing of an excitation clock employed for dynamic excitation by the charged particle device; and synchronizing, by the system, a second timing of the universal clock to the first timing of the excitation clock.

The computer-implemented method of any preceding paragraph, further comprising: employing, by the system, the universal clock absent an adjustment of the universal clock that is based on an environmental disturbance to the scientific instrument comprising a change in an XY position output, of the outputs.

The computer-implemented method of any preceding paragraph, further comprising: identifying, by the system, a time delay between different combinations of inputs, outputs or both of the inputs and outputs of the set, according to the universal clock.

The computer-implemented method of any preceding paragraph, further comprising: recording, by the system, a set of XY position outputs, of the outputs, from the charged particle device, wherein the recording comprises omitting recording of XY position outputs corresponding to beam blanking.

A computer program product facilitating a process for tracking scientific device inputs and outputs, the computer program product comprising a computer readable storage medium having program instructions embodied therewith, and the program instructions executable by a processor to cause the processor to: identify, by the processor, a set of inputs and outputs of a charged particle device; and track, by the processor, the inputs and outputs of the set based on a universal clock common to the inputs and outputs of the set.

The computer program product of the preceding paragraph, wherein the program instructions are further executable by the processor to cause the processor to: generate, by the processor, time stamps for the inputs and outputs based on a data output from the universal clock, wherein the time stamps are not affected by a change in an XY position output of the outputs.

The computer program product of any preceding paragraph, wherein the program instructions are further executable by the processor to cause the processor to: filter out, by the processor, an interference frequency output, of the outputs, that is affecting imaging outputs, of the outputs, by scanning for an interference frequency, corresponding to the interference frequency output, according to the universal clock.

The computer program product of any preceding paragraph, wherein the program instructions are further executable by the processor to cause the processor to: employ, by the processor, the universal clock absent an adjustment of the universal clock that is based on an environmental disturbance to the scientific instrument comprising a change in an XY position output, of the outputs.

The computer program product of any preceding paragraph, wherein the program instructions are further executable by the processor to cause the processor to: identify, by the processor, a time delay between different combinations of inputs, outputs or both of the inputs and outputs of the set, according to the universal clock.

### Scientific Instrument System Description

Turning next to FIG. 13, a detailed description is provided of additional context for the one or more embodiments described herein at FIGS. 1-12. One or more computing devices implementing any of the scientific instrument modules or methods disclosed herein can be part of a scientific instrument system. FIG. 13 illustrates a block diagram of an example scientific instrument system 1300 in which one or more of the scientific instrument methods or other methods disclosed herein can be performed, in accordance with various embodiments described herein. The scientific instrument modules and methods disclosed herein (e.g., the scientific instrument module 100 of FIG. 1 and the method 200 of FIG. 2) can be implemented by one or more of the scientific instrument 1310, the user local computing device 1320, the service local computing device 1330, and/or the remote computing device 1340 of the scientific instrument system 1300.

Any of the scientific instrument 1310, the user local computing device 1320, the service local computing device 1330, and/or the remote computing device 1340 can include any of the embodiments of the computing device 400 discussed herein with reference to FIG. 4, and any of the scientific instrument 1310, the user local computing device 1320, the service local computing device 1330, and/or the remote computing device 1340 can take the form of any appropriate one or more of the embodiments of the computing device 400 discussed herein with reference to FIG. 4.

One or more of the scientific instrument 1310, the user local computing device 1320, the service local computing device 1330, and/or the remote computing device 1340 can include a processing device 1302, a storage device 1304, and/or an interface device 1306. The processing device 1302 can take any suitable form, including the form of any of the processors 402 discussed herein with reference to FIG. 4. The processing devices 1302 included in different ones of the scientific instrument 1310, the user local computing device 1320, the service local computing device 1330, and/or the remote computing device 1340 can take the same form or different forms. The storage device 1304 can take any suitable form, including the form of any of the storage devices 404 discussed herein with reference to FIG. 4. The storage devices 1304 included in different ones of the scientific instrument 1310, the user local computing device 1320, the service local computing device 1330, and/or the remote computing device 1340 can take the same form or different forms. The interface device 1306 can take any suitable form, including the form of any of the interface devices 406 discussed herein with reference to FIG. 4. The interface devices 1306 included in different ones of the scientific instrument 1310, the user local computing device 1320, the service local computing device 1330, and/or the remote computing device 1340 can take the same form or different forms.

The scientific instrument 1310, the user local computing device 1320, the service local computing device 1330, and/or the remote computing device 1340 can be in communication with other elements of the scientific instrument system 1300 via communication pathways 1308. The communication pathways 1308 can communicatively couple the interface devices 1306 of different ones of the elements of the scientific instrument system 1300, as shown, and can be wired or wireless communication pathways (e.g., in accordance with any of the communication techniques discussed herein with reference to the interface devices 406 of the computing device 400 of FIG. 4). The particular scientific instrument system 1300 depicted in FIG. 13 includes communication pathways between each pair of the scientific instrument 1310, the user local computing device 1320, the service local computing device 1330, and the remote computing device 1340, but this "fully connected" implementation is simply illustrative, and in various embodiments, various ones of the communication pathways 1308 can be omitted. For example, in one or more embodiments, a service local computing device 1330 can omit a direct communication pathway 1308 between its interface device 1306 and the interface device 1306 of the scientific instrument 1310, but can instead communicate with the scientific instrument 1310 via the communication pathway 1308 between the service local computing device 1330 and the user local computing device 1320 and/or the communication pathway 1308 between the user local computing device 1320 and the scientific instrument 1310.

The scientific instrument 1310 can include any appropriate scientific instrument, such as a separation or MS instrument, or other instrument facilitating material analysis.

The user local computing device 1320 can be a computing device (e.g., in accordance with any of the embodiments of the computing device 400 discussed herein) that is local to a user of the scientific instrument 1310. In one or more embodiments, the user local computing device 1320 can also be local to the scientific instrument 1310, but this need not be the case; for example, a user local computing device 1320 that is associated with a home, office or other building associated with a user entity can be remote from, but in communication with, the scientific instrument 1310 so that the user entity can use the user local computing device 1320 to control and/or access data from the scientific instrument 1310. In one or more embodiments, the user local computing device 1320 can be a laptop, smartphone, or tablet device. In one or more embodiments the user local computing device 1320 can be a portable computing device. In one or more embodiments, the user local computing device 1320 can deployed in the field.

The service local computing device 1330 can be a computing device (e.g., in accordance with any of the embodiments of the computing device 400 discussed herein) that is local to an entity that services the scientific instrument 1310. For example, the service local computing device 1330 can be local to a manufacturer of the scientific instrument 1310 or to a third-party service company. In one or more embodiments, the service local computing device 1330 can communicate with the scientific instrument 1310, the user local computing device 1320, and/or the remote computing device 1340 (e.g., via a direct communication pathway 1308 or via multiple "indirect" communication pathways 1308, as discussed above) to receive data regarding the operation of the scientific instrument 1310, the user local computing device 1320, and/or the remote computing device 1340 (e.g., the results of self-tests of the scientific instrument 1310, calibration coefficients used by the scientific instrument 1310, the measurements of sensors associated with the scientific instrument 1310, etc.). In one or more embodiments, the service local computing device 1330 can communicate with the scientific instrument 1310, the user local computing device 1320, and/or the remote computing device 1340 (e.g., via a direct communication pathway 1308 or via multiple "indirect" communication pathways 1308, as discussed above) to transmit data to the scientific instrument 1310, the user local computing device 1320, and/or the remote computing device 1340 (e.g., to update programmed instructions, such as firmware, in the scientific instrument 1310, to initiate the performance of test or calibration sequences in the scientific instrument 1310, to update programmed instructions, such as software, in the user local computing device 1320 or the remote computing device 1340, etc.). A user entity of the scientific instrument 1310 can utilize the scientific instrument 1310 or the user local computing device 1320 to communicate with the service local computing device 1330 to report a problem with the scientific instrument 1310 or the user local computing device 1320, to request a visit from a technician to improve the operation of the scientific instrument 1310, to order consumables or replacement parts associated with the scientific instrument 1310, or for other purposes.

The remote computing device 1340 can be a computing device (e.g., in accordance with any of the embodiments of the computing device 400 discussed herein) that is remote from the scientific instrument 1310 and/or from the user local computing device 1320. In one or more embodiments, the remote computing device 1340 can be included in a datacenter or other large-scale server environment. In one or more embodiments, the remote computing device 1340 can include network-attached storage (e.g., as part of the storage device 1304). The remote computing device 1340 can store data generated by the scientific instrument 1310, perform analyses of the data generated by the scientific instrument 1310 (e.g., in accordance with programmed instructions), facilitate communication between the user local computing device 1320 and the scientific instrument 1310, and/or facilitate communication between the service local computing device 1330 and the scientific instrument 1310.

In one or more embodiments, one or more of the elements of the scientific instrument system 1300 illustrated in FIG. 13 can be omitted. Further, in one or more embodiments, multiple ones of various ones of the elements of the scientific instrument system 1300 of FIG. 13 can be present. For example, a scientific instrument system 1300 can include multiple user local computing devices 1320 (e.g., different user local computing devices 1320 associated with different user entities or in different locations). In another example, a scientific instrument system 1300 can include multiple scientific instruments 1310, all in communication with service local computing device 1330 and/or a remote computing device 1340; in such an embodiment, the service local computing device 1330 can monitor these multiple scientific instruments 1310, and the service local computing device 1330 can cause updates or other information can be "broadcast" to multiple scientific instruments 1310 at the same time. Different ones of the scientific instruments 1310 in a scientific instrument system 1300 can be located close to one another (e.g., in the same room) or farther from one another (e.g., on different floors of a building, in different buildings, in different cities, etc.). In one or more embodiments, a scientific instrument 1310 can be connected to an Internet-of-Things (IoT) stack that allows for command and control of the scientific instrument 1310 through a web-based application, a virtual or augmented reality application, a mobile application, and/or a desktop application. Any of these applications can be accessed by a user entity operating the user local computing device 1320 in communication with the scientific instrument 1310 by the intervening remote computing device 1340. In one or more embodiments, a scientific instrument 1310 can be sold by the manufacturer along with one or more associated user local computing devices 1320 as part of a local scientific instrument computing unit 1312.

In one or more embodiments, different ones of the scientific instruments 1310 included in a scientific instrument system 1300 can be different types of scientific instruments 1310; for example, one scientific instrument 1310 can be an EDS device, while another scientific instrument 1310 can be an analysis device that analyzes results of an EDS device. In some such embodiments, the remote computing device 1340 and/or the user local computing device 1320 can combine data from different types of scientific instruments 1310 included in a scientific instrument system 1300.

### Example Operating Environment

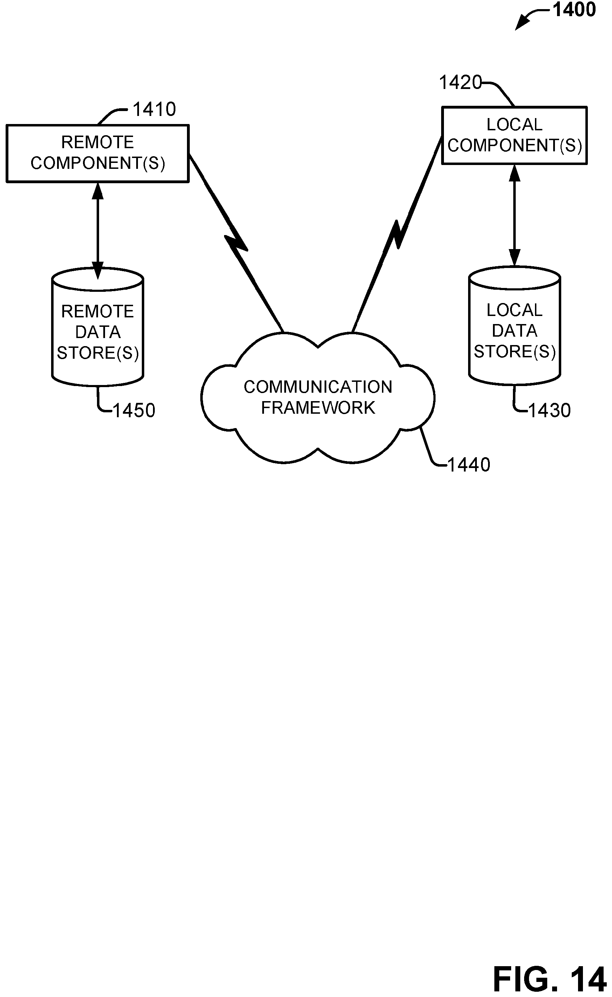

FIG. 14 is a schematic block diagram of an operating environment 1400 with which the described subject matter can interact. The operating environment 1400 comprises one or more remote component(s) 1410. The remote component(s) 1410 can be hardware and/or software (e.g., threads, processes, computing devices). In one or more embodiments, remote component(s) 1410 can be a distributed computer system, connected to a local automatic scaling component and/or programs that use the resources of a distributed computer system, via communication framework 1440. Communication framework 1440 can comprise wired network devices, wireless network devices, mobile devices, wearable devices, radio access network devices, gateway devices, femtocell devices, servers, etc.

The operating environment 1400 also comprises one or more local component(s) 1420. The local component(s) 1420 can be hardware and/or software (e.g., threads, processes, computing devices). In one or more embodiments, local component(s) 1420 can comprise an automatic scaling component and/or programs that communicate/use the remote resources 1410 and 1420, etc., connected to a remotely located distributed computing system via communication framework 1440.

One possible communication between a remote component(s) 1410 and a local component(s) 1420 can be in the form of a data packet adapted to be transmitted between two or more computer processes. Another possible communication between a remote component(s) 1410 and a local component(s) 1420 can be in the form of circuit-switched data adapted to be transmitted between two or more computer processes in radio time slots. The operating environment 1400 comprises a communication framework 1440 that can be employed to facilitate communications between the remote component(s) 1410 and the local component(s) 1420, and can comprise an air interface, e.g., interface of a UMTS network, via an LTE network, etc. Remote component(s) 1410 can be operably connected to one or more remote datastore(s) 1450, such as a hard drive, solid state drive, subscriber identity module (SIM) card, electronic SIM (eSIM), device memory, etc., that can be employed to store information on the remote component(s) 1410 side of communication framework 1440. Similarly, local component(s) 1420 can be operably connected to one or more local datastore(s) 1430, that can be employed to store information on the local component(s) 1420 side of communication framework 1440.

### Example Computing Environment

In order to provide additional context for various embodiments described herein, FIG. 15 and the following discussion are intended to provide a brief, general description of a suitable computing environment 1500 in which the various embodiments of the embodiment described herein can be implemented. While the embodiments have been described above in the general context of computer-executable instructions that can run on one or more computers, those skilled in the art will recognize that the embodiments can be also implemented in combination with other program modules and/or as a combination of hardware and software.

Generally, program modules include routines, programs, components, data structures, etc., that perform tasks or implement abstract data types. Moreover, the methods can be practiced with other computer system configurations, including single-processor or multiprocessor computer systems, minicomputers, mainframe computers, Internet of Things (IoT) devices, distributed computing systems, as well as personal computers, hand-held computing devices, microprocessor-based or programmable consumer electronics, and the like, each of which can be operatively coupled to one or more associated devices.

The illustrated embodiments of the embodiments herein can also be practiced in distributed computing environments where certain tasks are performed by remote processing devices that are linked through a communications network. In a distributed computing environment, program modules can be located in both local and remote memory storage devices.

Computing devices typically include a variety of media, which can include computer-readable storage media, machine-readable storage media, and/or communications media, which two terms are used herein differently from one another as follows. Computer-readable storage media or machine-readable storage media can be any available storage media that can be accessed by the computer and includes both volatile and nonvolatile media, removable and non-removable media. By way of example, and not limitation, computer-readable storage media or machine-readable storage media can be implemented in connection with any method or technology for storage of information such as computer-readable or machine-readable instructions, program modules, structured data, or unstructured data.

Computer-readable storage media can include, but are not limited to, random access memory (RAM), read only memory (ROM), electrically erasable programmable read only memory (EEPROM), flash memory or other memory technology, compact disk read only memory (CD ROM), digital versatile disk (DVD), Blu-ray disc (BD) or other optical disk storage, magnetic cassettes, magnetic tape, magnetic disk storage or other magnetic storage devices, solid state drives or other solid state storage devices, or other tangible and/or non-transitory media which can be used to store desired information. In this regard, the terms "tangible" or "non-transitory" herein as applied to storage, memory, or computer-readable media, exclude only propagating transitory signals per se as modifiers and do not relinquish rights to all standard storage, memory or computer-readable media that are not only propagating transitory signals per se.

Computer-readable storage media can be accessed by one or more local or remote computing devices, e.g., via access requests, queries, or other data retrieval protocols, for a variety of operations with respect to the information stored by the medium.

Communications media typically embody computer-readable instructions, data structures, program modules or other structured or unstructured data in a data signal such as a modulated data signal, e.g., a carrier wave or other transport mechanism, and includes any information delivery or transport media. The term "modulated data signal" or signals refers to a signal that has one or more of its characteristics set or changed in such a manner as to encode information in one or more signals. By way of example, and not limitation, communication media include wired media, such as a wired network or direct-wired connection, and wireless media such as acoustic, RF, infrared and other wireless media.

Referring still to FIG. 15, the example computing environment 1500 which can implement one or more embodiments described herein includes a computer 1502, the computer 1502 including a processing unit 1504, a system memory 1506 and a system bus 1508. The system bus 1508 couples system components including, but not limited to, the system memory 1506 to the processing unit 1504. The processing unit 1504 can be any of various commercially available processors. Dual microprocessors and other multi processor architectures can also be employed as the processing unit 1504.

The system bus 1508 can be any of several types of bus structure that can further interconnect to a memory bus (with or without a memory controller), a peripheral bus, and a local bus using any of a variety of commercially available bus architectures. The system memory 1506 includes ROM 1510 and RAM 1512. A basic input/output system (BIOS) can be stored in a non-volatile memory such as ROM, erasable programmable read only memory (EPROM), EEPROM, which BIOS contains the basic routines that help to transfer information between elements within the computer 1502, such as during startup. The RAM 1512 can also include a high-speed RAM such as static RAM for caching data.

The computer 1502 further includes an internal hard disk drive (HDD) 1514 (e.g., EIDE, SATA), and can include one or more external storage devices 1516 (e.g., a magnetic floppy disk drive (FDD) 1516, a memory stick or flash drive reader, a memory card reader, etc.). While the internal HDD 1514 is illustrated as located within the computer 1502, the internal HDD 1514 can also be configured for external use in a suitable chassis (not shown). Additionally, while not shown in computing environment 1500, a solid-state drive (SSD) could be used in addition to, or in place of, an HDD 1514.

Other internal or external storage can include at least one other storage device 1520 with storage media 1522 (e.g., a solid-state storage device, a nonvolatile memory device, and/or an optical disk drive that can read or write from removable media such as a CD-ROM disc, a DVD, a BD, etc.). The external storage 1516 can be facilitated by a network virtual machine. The HDD 1514, external storage device 1516 and storage device (e.g., drive) 1520 can be connected to the system bus 1508 by an HDD interface 1524, an external storage interface 1526 and a drive interface 1528, respectively.

The drives and their associated computer-readable storage media provide nonvolatile storage of data, data structures, computer-executable instructions, and so forth. For the computer 1502, the drives and storage media accommodate the storage of any data in a suitable digital format. Although the description of computer-readable storage media above refers to respective types of storage devices, other types of storage media which are readable by a computer, whether presently existing or developed in the future, could also be used in the example operating environment, and further, that any such storage media can contain computer-executable instructions for performing the methods described herein.

A number of program modules can be stored in the drives and RAM 1512, including an operating system 1530, one or more application programs 1532, other program modules 1534 and program data 1536. All or portions of the operating system, applications, modules, and/or data can also be cached in the RAM 1512. The systems and methods described herein can be implemented utilizing various commercially available operating systems or combinations of operating systems.

Computer 1502 can optionally comprise emulation technologies. For example, a hypervisor (not shown) or other intermediary can emulate a hardware environment for operating system 1530, and the emulated hardware can optionally be different from the hardware illustrated in FIG. 15. In such an embodiment, operating system 1530 can comprise one virtual machine (VM) of multiple VMs hosted at computer 1502. Furthermore, operating system 1530 can provide runtime environments, such as the Java runtime environment or the .NET framework, for applications 1532. Runtime environments are consistent execution environments that allow applications 1532 to run on any operating system that includes the runtime environment. Similarly, operating system 1530 can support containers, and applications 1532 can be in the form of containers, which are lightweight, standalone, executable packages of software that include, e.g., code, runtime, system tools, system libraries and settings for an application.

Further, computer 1502 can be enabled with a security module, such as a trusted processing module (TPM). For instance, with a TPM, boot components hash next in time boot components, and wait for a match of results to secured values, before loading a next boot component. This process can take place at any layer in the code execution stack of computer 1502, e.g., applied at the application execution level or at the operating system (OS) kernel level, thereby enabling security at any level of code execution.

A user entity can enter commands and information into the computer 1502 through one or more wired/wireless input devices, e.g., a keyboard 1538, a touch screen 1540, and a pointing device, such as a mouse 1542. Other input devices (not shown) can include a microphone, an infrared (IR) remote control, a radio frequency (RF) remote control, or other remote control, a joystick, a virtual reality controller and/or virtual reality headset, a game pad, a stylus pen, an image input device, e.g., camera, a gesture sensor input device, a vision movement sensor input device, an emotion or facial detection device, a biometric input device, e.g., fingerprint or iris scanner, or the like. These and other input devices are often connected to the processing unit 1504 through an input device interface 1544 that can be coupled to the system bus 1508, but can be connected by other interfaces, such as a parallel port, an IEEE 1394 serial port, a game port, a USB port, an IR interface, a BLUETOOTH^{®} interface, etc.

A monitor 1546 or other type of display device can also be connected to the system bus 1508 via an interface, such as a video adapter 1548. In addition to the monitor 1546, a computer typically includes other peripheral output devices (not shown), such as speakers, printers, etc.

The computer 1502 can operate in a networked environment using logical connections via wired and/or wireless communications to one or more remote computers, such as a remote computer 1550. The remote computer 1550 can be a workstation, a server computer, a router, a personal computer, portable computer, microprocessor-based entertainment appliance, a peer device or other common network node, and typically includes many or all of the elements described relative to the computer 1502, although, for purposes of brevity, only a memory/storage device 1552 is illustrated. The logical connections depicted include wired/wireless connectivity to a local area network (LAN) 1554 and/or larger networks, e.g., a wide area network (WAN) 1556. Such LAN and WAN networking environments are commonplace in offices and companies, and facilitate enterprise-wide computer networks, such as intranets, all of which can connect to a global communications network, e.g., the Internet.

When used in a LAN networking environment, the computer 1502 can be connected to the local network 1554 through a wired and/or wireless communication network interface or adapter 1558. The adapter 1558 can facilitate wired or wireless communication to the LAN 1554, which can also include a wireless access point (AP) disposed thereon for communicating with the adapter 1558 in a wireless mode.

When used in a WAN networking environment, the computer 1502 can include a modem 1560 or can be connected to a communications server on the WAN 1556 via other means for establishing communications over the WAN 1556, such as by way of the Internet. The modem 1560, which can be internal or external and a wired or wireless device, can be connected to the system bus 1508 via the input device interface 1544. In a networked environment, program modules depicted relative to the computer 1502 or portions thereof, can be stored in the remote memory/storage device 1552. The network connections shown are example and other means of establishing a communications link between the computers can be used.

When used in either a LAN or WAN networking environment, the computer 1502 can access cloud storage systems or other network-based storage systems in addition to, or in place of, external storage devices 1516 as described above. Generally, a connection between the computer 1502 and a cloud storage system can be established over a LAN 1554 or WAN 1556 e.g., by the adapter 1558 or modem 1560, respectively. Upon connecting the computer 1502 to an associated cloud storage system, the external storage interface 1526 can, with the aid of the adapter 1558 and/or modem 1560, manage storage provided by the cloud storage system as it would other types of external storage. For instance, the external storage interface 1526 can be configured to provide access to cloud storage sources as if those sources were physically connected to the computer 1502.

The computer 1502 can be operable to communicate with any wireless devices or entities operatively disposed in wireless communication, e.g., a printer, scanner, desktop and/or portable computer, portable data assistant, communications satellite, any piece of equipment or location associated with a wirelessly detectable tag (e.g., a kiosk, news stand, store shelf, etc.), and telephone. This can include Wireless Fidelity (Wi-Fi) and BLUETOOTH^{®} wireless technologies. Thus, the communication can be a defined structure as with an existing network or simply an ad hoc communication between at least two devices.

### Additional Information

The embodiments described herein can be directed to one or more of a system, a method, an apparatus and/or a computer program product at any possible technical detail level of integration. The computer program product can include a computer readable storage medium (or media) having computer readable program instructions thereon for causing a processor to carry out aspects of the one or more embodiments described herein. The computer readable storage medium can be a tangible device that can retain and store instructions for use by an instruction execution device. The computer readable storage medium can be, for example, but is not limited to, an electronic storage device, a magnetic storage device, an optical storage device, an electromagnetic storage device, a superconducting storage device and/or any suitable combination of the foregoing. A non-exhaustive list of more specific examples of the computer readable storage medium can also include the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon and/or any suitable combination of the foregoing. A computer readable storage medium, as used herein, is not to be construed as being transitory signals per se, such as radio waves and/or other freely propagating electromagnetic waves, electromagnetic waves propagating through a waveguide and/or other transmission media (e.g., light pulses passing through a fiber-optic cable), and/or electrical signals transmitted through a wire.

Computer readable program instructions described herein can be downloaded to respective computing/processing devices from a computer readable storage medium and/or to an external computer or external storage device via a network, for example, the Internet, a local area network, a wide area network and/or a wireless network. The network can comprise copper transmission cables, optical transmission fibers, wireless transmission, routers, firewalls, switches, gateway computers and/or edge servers. A network adapter card or network interface in each computing/processing device receives computer readable program instructions from the network and forwards the computer readable program instructions for storage in a computer readable storage medium within the respective computing/processing device. Computer readable program instructions for carrying out operations of the one or more embodiments described herein can be assembler instructions, instruction-set-architecture (ISA) instructions, machine instructions, machine dependent instructions, microcode, firmware instructions, state-setting data, configuration data for integrated circuitry, and/or source code and/or object code written in any combination of one or more programming languages, including an object oriented programming language such as Smalltalk, C++ or the like, and/or procedural programming languages, such as the "C" programming language and/or similar programming languages. The computer readable program instructions can execute entirely on a computer, partly on a computer, as a stand-alone software package, partly on a computer and/or partly on a remote computer or entirely on the remote computer and/or server. In the latter scenario, the remote computer can be connected to a computer through any type of network, including a local area network (LAN) and/or a wide area network (WAN), and/or the connection can be made to an external computer (for example, through the Internet using an Internet Service Provider). In one or more embodiments, electronic circuitry including, for example, programmable logic circuitry, field-programmable gate arrays (FPGA) and/or programmable logic arrays (PLA) can execute the computer readable program instructions by utilizing state information of the computer readable program instructions to personalize the electronic circuitry, in order to perform aspects of the one or more embodiments described herein.

Aspects of the one or more embodiments described herein are described with reference to flowchart illustrations and/or block diagrams of methods, apparatus (systems), and computer program products according to one or more embodiments described herein. It will be understood that each block of the flowchart illustrations and/or block diagrams, and combinations of blocks in the flowchart illustrations and/or block diagrams, can be implemented by computer readable program instructions. These computer readable program instructions can be provided to a processor of a general-purpose computer, special purpose computer and/or other programmable data processing apparatus to produce a machine, such that the instructions, which execute via the processor of the computer or other programmable data processing apparatus, can create means for implementing the functions/acts specified in the flowchart and/or block diagram block or blocks. These computer readable program instructions can also be stored in a computer readable storage medium that can direct a computer, a programmable data processing apparatus and/or other devices to function in a particular manner, such that the computer readable storage medium having instructions stored therein can comprise an article of manufacture including instructions which can implement aspects of the function/act specified in the flowchart and/or block diagram block or blocks. The computer readable program instructions can also be loaded onto a computer, other programmable data processing apparatus and/or other device to cause a series of operational acts to be performed on the computer, other programmable apparatus and/or other device to produce a computer implemented process, such that the instructions which execute on the computer, other programmable apparatus and/or other device implement the functions/acts specified in the flowchart and/or block diagram block or blocks.

The flowcharts and block diagrams in the figures illustrate the architecture, functionality and/or operation of possible implementations of systems, computer-implementable methods and/or computer program products according to one or more embodiments described herein. In this regard, each block in the flowchart or block diagrams can represent a module, segment and/or portion of instructions, which comprises one or more executable instructions for implementing the specified logical function. In one or more alternative implementations, the functions noted in the blocks can occur out of the order noted in the Figures. For example, two blocks shown in succession can be executed substantially concurrently, and/or the blocks can sometimes be executed in the reverse order, depending upon the functionality involved. It will also be noted that each block of the block diagrams and/or flowchart illustration, and/or combinations of blocks in the block diagrams and/or flowchart illustration, can be implemented by special purpose hardware-based systems that can perform the specified functions and/or acts and/or carry out one or more combinations of special purpose hardware and/or computer instructions.

While the subject matter has been described above in the general context of computer-executable instructions of a computer program product that runs on a computer and/or computers, those skilled in the art will recognize that the one or more embodiments herein also can be implemented at least partially in parallel with one or more other program modules. Generally, program modules include routines, programs, components and/or data structures that perform particular tasks and/or implement particular abstract data types. Moreover, the aforedescribed computer-implemented methods can be practiced with other computer system configurations, including single-processor and/or multiprocessor computer systems, mini-computing devices, mainframe computers, as well as computers, hand-held computing devices (e.g., PDA, phone), and/or microprocessor-based or programmable consumer and/or industrial electronics. The illustrated aspects can also be practiced in distributed computing environments in which tasks are performed by remote processing devices that are linked through a communications network. However, one or more, if not all aspects of the one or more embodiments described herein can be practiced on stand-alone computers. In a distributed computing environment, program modules can be located in both local and remote memory storage devices.

As used in this application, the terms "component," "system," "platform" and/or "interface" can refer to and/or can include a computer-related entity or an entity related to an operational machine with one or more specific functionalities. The entities described herein can be either hardware, a combination of hardware and software, software, or software in execution. For example, a component can be, but is not limited to being, a process running on a processor, a processor, an object, an executable, a thread of execution, a program and/or a computer. By way of illustration, both an application running on a server and the server can be a component. One or more components can reside within a process and/or thread of execution and a component can be localized on one computer and/or distributed between two or more computers. In another example, respective components can execute from various computer readable media having various data structures stored thereon. The components can communicate via local and/or remote processes such as in accordance with a signal having one or more data packets (e.g., data from one component interacting with another component in a local system, distributed system and/or across a network such as the Internet with other systems via the signal). As another example, a component can be an apparatus with specific functionality provided by mechanical parts operated by electric or electronic circuitry, which is operated by a software and/or firmware application executed by a processor. In such a case, the processor can be internal and/or external to the apparatus and can execute at least a part of the software and/or firmware application. As yet another example, a component can be an apparatus that provides specific functionality through electronic components without mechanical parts, where the electronic components can include a processor and/or other means to execute software and/or firmware that confers at least in part the functionality of the electronic components. In an aspect, a component can emulate an electronic component via a virtual machine, e.g., within a cloud computing system.

In addition, the term "or" is intended to mean an inclusive "or" rather than an exclusive "or." That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. Moreover, articles "a" and "an" as used in the subject specification and annexed drawings should generally be construed to mean "one or more" unless specified otherwise or clear from context to be directed to a singular form. As used herein, the terms "example" and/or "exemplary" are utilized to mean serving as an example, instance, or illustration. For the avoidance of doubt, the subject matter described herein is not limited by such examples. In addition, any aspect or design described herein as an "example" and/or "exemplary" is not necessarily to be construed as preferred or advantageous over other aspects or designs, nor is it meant to preclude equivalent exemplary structures and techniques known to those of ordinary skill in the art.

As it is employed in the subject specification, the term "processor" can refer to substantially any computing processing unit and/or device comprising, but not limited to, single-core processors; single-processors with software multithread execution capability; multi-core processors; multi-core processors with software multithread execution capability; multi-core processors with hardware multithread technology; parallel platforms; and/or parallel platforms with distributed shared memory. Additionally, a processor can refer to an integrated circuit, an application specific integrated circuit (ASIC), a digital signal processor (DSP), a field programmable gate array (FPGA), a programmable logic controller (PLC), a complex programmable logic device (CPLD), a discrete gate or transistor logic, discrete hardware components, and/or any combination thereof designed to perform the functions described herein. Further, processors can exploit nano-scale architectures such as, but not limited to, molecular based transistors, switches and/or gates, in order to optimize space usage and/or to enhance performance of related equipment. A processor can be implemented as a combination of computing processing units.

Herein, terms such as "store," "storage," "datastore," data storage," "database," and substantially any other information storage component relevant to operation and functionality of a component are utilized to refer to "memory components," entities embodied in a "memory," or components comprising a memory. Memory and/or memory components described herein can be either volatile memory or nonvolatile memory or can include both volatile and nonvolatile memory. By way of illustration, and not limitation, nonvolatile memory can include read only memory (ROM), programmable ROM (PROM), electrically programmable ROM (EPROM), electrically erasable ROM (EEPROM), flash memory and/or nonvolatile random-access memory (RAM) (e.g., ferroelectric RAM (FeRAM). Volatile memory can include RAM, which can act as external cache memory, for example. By way of illustration and not limitation, RAM can be available in many forms such as synchronous RAM (SRAM), dynamic RAM (DRAM), synchronous DRAM (SDRAM), double data rate SDRAM (DDR SDRAM), enhanced SDRAM (ESDRAM), Synchlink DRAM (SLDRAM), direct Rambus RAM (DRRAM), direct Rambus dynamic RAM (DRDRAM) and/or Rambus dynamic RAM (RDRAM). Additionally, the described memory components of systems and/or computer-implemented methods herein are intended to include, without being limited to including, these and/or any other suitable types of memory.

What has been described above includes mere examples of systems and computer-implemented methods. It is, of course, not possible to describe every conceivable combination of components and/or computer-implemented methods for purposes of describing the one or more embodiments, but one of ordinary skill in the art can recognize that many further combinations and/or permutations of the one or more embodiments are possible. Furthermore, to the extent that the terms "includes," "has," "possesses," and the like are used in the detailed description, claims, appendices and/or drawings such terms are intended to be inclusive in a manner similar to the term "comprising" as "comprising" is interpreted when employed as a transitional word in a claim.

The descriptions of the various embodiments can use the phrases "an embodiment," "various embodiments," "one or more embodiments" and/or "some embodiments," each of which can refer to one or more of the same or different embodiments.

The descriptions of the various embodiments have been presented for purposes of illustration but are not intended to be exhaustive or limited to the embodiments described herein. Many modifications and variations will be apparent to those of ordinary skill in the art without departing from the scope and spirit of the described embodiments. The terminology used herein was chosen to best explain the principles of the embodiments, the practical application and/or technical improvement over technologies found in the marketplace, and/or to enable others of ordinary skill in the art to understand the embodiments described herein.

## Claims

1. A system, comprising:
a memory that stores computer executable components; and
a processor that executes the computer executable components stored in the memory, wherein the computer executable components comprise:
an identifying component that identifies a set of inputs and outputs of a charged particle device; and
a parameterizing component that tracks the inputs and outputs of the set based on a universal clock common to the inputs and outputs of the set.

2. The system of claim 1, wherein the inputs and outputs of the set comprise XY position inputs and outputs and detection inputs and outputs.

3. The system of claim 1, wherein the computer executable components further comprise:
a stamping component that time stamps the inputs and outputs with time stamps based on data output from the universal clock,
wherein the time stamps are not affected by a change in an XY position output of the outputs.

4. The system of claim 1, wherein the computer executable components further comprise:
a filtering component that filters out an interference frequency output, of the outputs, that is affecting imaging outputs, of the outputs, by scanning for an interference frequency, corresponding to the interference frequency output, according to the universal clock.

5. The system of claim 1, wherein the computer executable components further comprise:
a synchronizing component that determines a second timing of an excitation clock employed for dynamic excitation by the scientific instrument and synchronizes a first timing of the universal clock to the second timing of the excitation clock.

6. The system of claim 1, wherein the universal clock is employed absent an adjustment of the universal clock that is based on an environmental disturbance to the scientific instrument comprising a change in an XY position output, of the outputs.

7. The system of claim 1, wherein the computer executable components further comprise:
an evaluating component that identifies a time delay between different combinations of inputs, outputs or both, of the inputs and outputs of the set, according to the universal clock.

8. The system of claim 1, wherein the computer executable components further comprise:
a recording component that records a set of XY position outputs, of the outputs, from the scientific instrument,
wherein the recording component omits recording of XY position outputs corresponding to beam blanking.

9. A computer-implemented method, comprising:
identifying, by a system operatively coupled to a processor, a set of inputs and outputs of a scientific instrument; and
tracking, by the system, the inputs and outputs of the set based on a universal clock common to the inputs and outputs of the set.

10. The computer-implemented method of claim 9, further comprising:
generating, by the system, time stamps for the inputs and outputs, based on data output from the universal clock, wherein the time stamps are not affected by a change in an XY position output of the outputs.

11. The computer-implemented method of claim 9, further comprising:
filtering out, by the system, an interference frequency output, of the outputs, that is affecting imaging outputs, of the outputs, by scanning for an interference frequency, corresponding to the interference frequency output, according to the universal clock.

12. The computer-implemented method of claim 9, further comprising:
determining, by the system, a first timing of an excitation clock employed for dynamic excitation by the scientific instrument; and
synchronizing, by the system, a second timing of the universal clock to the first timing of the excitation clock.

13. The computer-implemented method of claim 9, further comprising:
employing, by the system, the universal clock absent an adjustment of the universal clock that is based on an environmental disturbance to the scientific instrument comprising a change in an XY position output, of the outputs.

14. The computer-implemented method of claim 9, further comprising:
identifying, by the system, a time delay between different combinations of inputs, outputs or both of the inputs and outputs of the set, according to the universal clock.

15. The computer-implemented method of claim 9, further comprising:
recording, by the system, a set of XY position outputs, of the outputs, from the scientific instrument,
wherein the recording comprises omitting recording of XY position outputs corresponding to beam blanking.

16. A computer program product facilitating a process for tracking scientific device inputs and outputs, the computer program product comprising a computer readable storage medium having program instructions embodied therewith, and the program instructions executable by a processor to cause the processor to:
identify, by the processor, a set of inputs and outputs of a scientific instrument; and
track, by the processor, the inputs and outputs of the set based on a universal clock common to the inputs and outputs of the set.

17. The computer program product of claim 16, wherein the program instructions are further executable by the processor to cause the processor to:
generate, by the processor, time stamps for the inputs and outputs based on a data output from the universal clock, wherein the time stamps are not affected by a change in an XY position output of the outputs.

18. The computer program product of claim 16, wherein the program instructions are further executable by the processor to cause the processor to:
filter out, by the processor, an interference frequency output, of the outputs, that is affecting imaging outputs, of the outputs, by scanning for an interference frequency, corresponding to the interference frequency output, according to the universal clock.

19. The computer program product of claim 16, wherein the program instructions are further executable by the processor to cause the processor to:
employ, by the processor, the universal clock absent an adjustment of the universal clock that is based on an environmental disturbance to the scientific instrument comprising a change in an XY position output, of the outputs.

20. The computer program product of claim 16, wherein the program instructions are further executable by the processor to cause the processor to:
identify, by the processor, a time delay between different combinations of inputs, outputs or both of the inputs and outputs of the set, according to the universal clock.
